Europäisches Patentamt

(19) European Patent Office

Office européen des brevets

(11) Numéro de publication: **0 211 438**
**B1**

(12) **FASCICULE DE BREVET EUROPEEN**

(45) Date de publication du fascicule du brevet: **09.05.90**

(51) Int. Cl.⁵: **H 04 L 25/49,** G 11 B 20/14, H 03 M 5/12

(21) Numéro de dépôt: **86110790.2**

(22) Date de dépôt: **05.08.86**

(54) **Dispositif de transmission de paquets dans un réseau temporel asynchrone et procédé de codage des silences.**

(30) Priorité: **07.08.85 FR 8512092**

(43) Date de publication de la demande:
**25.02.87 Bulletin 87/09**

(45) Mention de la délivrance du brevet:
**09.05.90 Bulletin 90/19**

(84) Etats contractants désignés:
**BE CH DE FR GB IT LI NL SE**

(56) Documents cités:
EP-A-0 081 750
DE-A-3 331 205
GB-A-2 046 484
US-A-3 962 647
US-A-4 350 973
US-A-4 355 423
US-A-4 417 320

ELECTRONIC DESIGN, vol.30, no.16, aou7t 1982,
pages 201-212; Waseca, US; L. SANDERS: "For
data-comm links, Manchester chip could be
best"

(73) Titulaire: **ALCATEL CIT**
**12 Rue de la Baume**
**F-75008 Paris (FR)**

(72) Inventeur: **Bueno, Serge**
**12 rue de la Prairie**
**F-91000 Bondoufle (FR)**
Inventeur: **Bourbon, Philippe**
**15 avenue du Maréchal Leclerc**
**F-92360 Meudon (FR)**

(74) Mandataire: **Weinmiller, Jürgen et al**
**Lennéstrasse 9 Postfach 24**
**D-8133 Feldafing (DE)**

(56) Documents cités:
**COMPUTER DESIGN, décembre 1979, pages
93-99; Concord, Mass., US; D.R. BRICKNER:
"Military multiplex standard defines versatile
serial bus"**

Courier Press, Leamington Spa, England.

**Description**

L'invention concerne la transmission de paquets dans un réseau temporel asynchrone.

Pour être acheminée, toute information doit être codée, c'est-à-dire être mise sous forme de symboles; la signification de ces symboles est fondamentale mais est une pure affaire de convention entre un émetteur et un récepteur. A cette notion de codage s'ajoute un autre élément qui est le mode de transmission. La transmission en mode paquet est un mode de transmission numérique dans lequel les données numériques à transmettre sont groupées en paquets et associées à l'intérieur de chaque paquet à des informations de routage et de recouvrement d'erreur, la durée entre paquets étant variable et identifiable sans ambiguïté, cette durée correspondant à un silence.

En transmission de paquets il est nécessaire d'une part de délimiter avec précision à la réception les paquets et les silences et d'autre part de prendre en compte, à la réception les données reçues, celles-ci arrivant au rythme de l'horloge distante et étant prises en compte à ce rythme.

L'invention a pour but de permettre une délimitation précise des paquets et des silences.

L'invention a également pour but une prise en compte simple à la réception, des données reçues permettant une intégration du dispositif effectuant cette prise en compte.

L'invention a pour objet un procédé de codage des silences séparant les paquets dans une transmission de paquets, chaque paquet étant constitué de quartets de données délivrés par un émetteur en code Manchester, à destination d'un récepteur, caractérisé par le fait que l'émetteur délivre, pendant les silences et en alternance, deux types de quartets vides inverses l'un de l'autre et comportant chacun quatre bits de valeurs alternées, et que seuls les troisième et quatrième bits de chaque quartet vide comportent une transition médiane selon le code Manchester, un quartet vide d'un premier type ayant un premier bit de niveau 0, un deuxième bit de niveau 1, un troisième bit de valeur 0 et un quatrième bit de valeur 1, un quartet vide d'un deuxième type ayant un premier bit de niveau 1, un deuxième bit de niveau 0, un troisième bit de valeur 1 et un quatrième bit de valeur 0.

L'invention a également pour objet un procédé de codage des silences selon la revendication 1, caractérisé par le fait que l'émetteur délivre, à la suite d'un dernier quartet de données d'un paquet, un quartet vide donnant une transition avec ledit dernier quartet de données, ledit quartet vide étant du premier type lorsque le dernier quartet de données se termine par un bit de valeur 0, et du deuxième type lorsque le dernier quartet de données se termine par un bit de valeur 1.

L'invention a aussi pour objet un dispositif de transmission de paquets dans un réseau temporel asynchrone, chaque silence séparant deux paquets étant codé selon le procédé de la revendication 2, dispositif comportant un émetteur et un récepteur reliés par une liaison de données acheminant des quartets de données en code Manchester, chaque bit en code Manchester étant constitué par deux demi-bits de valeur différente, et des quartets vides, caractérisé par le fait que l'émetteur comporte une horloge, un codeur et un circuit émetteur différentiel relié en sortie à la liaison de données, l'horloge délivrant un premier signal d'horloge, un deuxième signal d'horloge obtenu par division par huit du premier signal d'horloge, et en signal de chargement à chaque début d'une première demi-période du deuxième signal d'horloge, que le codeur comporte une mémoire morte, un registre du type parallèle-série piloté par le premier signal d'horloge et recevant sur une entrée chargement le signal de chargement, ledit registre ayant une sortie série reliée au circuit émetteur différentiel, une bascule pilotée par le deuxième signal d'horloge, que la mémoire morte est reliée en entrée à une liaison d'information délivrant en parallèle quatre bits en code NRZ constituant un quartet d'informations, et lesdits quatre bits ayant tous la valeur 0 lors des silences, à une liaison de parité délivrant un bit de parité pour chaque quartet d'information, à une liaison enveloppe délivrant un signal de valeur 1 pendant toute la durée d'un paquet, à l'horloge de laquelle elle reçoit le deuxième signal d'horloge, et à la sortie de la bascule, que la mémoire morte a huit sorties parallèles reliées aux entrées parallèles du registre, la première sorte de la mémoire morte étant également reliée à une entrée de la bascule, la mémoire morte délivrant un quartet de données en code Manchester à chaque quartet d'information reçu et des quartets vides lors des silences, la première sortie de la mémoire morte délivrant un bit dont la valeur correspond au niveau du dernier demi-bit du quartet délivré, que la bascule mémorise ledit bit délivré par ladite première sortie de la mémoire morte et délivre un signal état du dernier demi-bit du quartet, que les quatre bits d'un quartet d'information, le bit de parité, le signal enveloppe, le deuxième signal d'horloge et le signal état du dernier demi-bit constituent une adresse de la mémoire morte, que la mémoire morte délivre, pendant une première demi-période du deuxième signal d'horloge, huit bits correspondant à un quartet de données lorsque le signal enveloppe à la valeur 1, à un premier quartet vide lorsque le signal enveloppe a la valeur 0 et le signal état du dernier demi-bit a la valeur 1, et un deuxième quartet vide lorsque le signal enveloppe a la valeur 0 et le signal état du dernier demi-bit a la valeur 0.

L'invention a encore pour objet un dispositif de transmission de paquets dans un réseau temporel asynchrone caractérisé par le fait que le récepteur comporte un décodeur comprenant un registre d'entrée du type série-parallèle, une mémoire morte, un registre de sortie du type parallèle-parallèle un compteur, une première une deuxième et une troisième portes OU-NON et une porte OU exclusif, que le registre d'entrée et le compteur ont chacun une entrée horloge reliée à l'entrée du décodeur, que le registre d'entrée a une entrée de données reliée à la ligne de données et huit sorties parallèles reliées à huit entrées parallèles de la mémoire morte pour adressage de ladite mémoire morte, que la mémoire morte a huit sorties parallèles, une première, une deuxième, une troisième et une quatrième sorties délivrant chacune un bit d'information d'un quartet d'information et étant reliées à une première, une deuxième, une troisième et une quatrième entrées parallèles du registre de sortie, une cinquième sortie délivrant un signal faute reliée à une cinquième entrée du registre de sortie, une sixième sortie délivrant un signal de silence reliée à une entrée de chacune des première et troisième portes OU-NON, une septième sortie délivrant un signal de silence inversé reliée à une entrée de chargement du compteur, et une huitième sortie délivrant un signal de parité et reliée à une septième entrée du registre de sortie, que le registre de sortie a huite sorties correspondant chacune à une entrée dudit registre de sortie, les première, deuxième, troisième et quatrième sorties du registre de sortie délivrant les quatre bits du quartet d'information et étant reliées à la liaison de sortie de données, la cinquième sortie étant reliée à la liaison de sortie faute, la sixième sortie étant reliée à la liaison de sortie enveloppe et la septième sortie étant reliée à la liaison de sortie de parité, la huitième sortie étant reliée à la liaison synchronisation, que la première porte OU-NON a une autre entrée reliée à la liaison de sortie synchronisation et une sortie reliée à une entrée de la deuxième porte OU-NON dont une autre entrée est reliée à la liaison de sortie faute, la deuxième porte OU-NON ayant une sortie reliée à une entrée de la porte OU exclusif et à la huitième entrée du registre de sortie, que la porte OU exclusif a une autre entrée portée à un potentiel positif et une sortie reliée à une autre entrée de la troisième porte OU-NON dont une sortie est reliée à la sixième entrée du registre de sortie, et que le compteur est relié en sortie à une entrée horloge du registre de sortie, ledit compteur délivrant un deuxième signal d'horloge distant obtenu par division par huit du premier signal d'horloge distant reçu par le compteur.

Le procédé de codage des silences de l'invention permet une identification immédiate et sans ambiguïté de la durée inter-paquets, cette identification étant réalisée par une modification de la régle de codage Manchester; il permet un détection immédiate de la durée inter-paquets (silences) et donc du début d'un paquet sans aucune perte d'information, puisqu'il n'y a aucun algorithme de synchronisation (mot de synchronisation) contrairement par exemple au protocole HDB3 où pendant l'exécution de l'algorithme de synchronisation il y a perte d'information.

Autre avantage du procédé de l'invention il n'y a pas d'insertion de zéros contrairement au protocole HDLC; ainsi un paquet ne contient que des informations utiles; de plus aucune configuration de bits à transmettre n'est interdite.

Le procédé de l'invention présente également l'avantage de pouvoir transmettre en permanence un signal d'horloge lorsqu'il n'y a qu'une ligne entre émetteur et récepteur. Ainsi il n'y a pas de perte de signal d'horloge entre les paquets, ce qui permet de différencier une coupure de ligne d'une absence de paquet.

Un autre avantage du procédé de l'invention réside dans le fait que les motifs de délimitation des paquets, appelés quartets vides, présentent une composante continue nulle, comme les quartets de données d'un paquet qui sont en code Manchester, ce qui permet la transmission des paquets sur une grande distance. De plus les informations à transmettre étant constituées par quartets d'information, c'est-à-dire par ensembles de quatre bits d'information, la vérification du nombre de bits d'un paquet constitue une protection supplémentaire contre les erreurs. Il est également possible de transmettre des paquets de taille variable séparés, par des durées inter-paquets également variables.

L'utilisation d'un signal contenant des violations de la règle du code comme signal de synchronisation est connu du document DE—A—3331205.

L'invention va être décrite à l'aide d'exemples de réalisation illustrés par les figures annexées dans lesquelles:

la figure 1 est un schéma général d'un dispositif de transmission selon l'invention;

la figure 2 représente le circuit d'horloge de la figure 1,

la figure 3 représente le codeur de la figure 1,

la figure 4 représente en A) un bit de valeur "1" et en B) un bit de valeur "0" en code Manchester,

la figure 5 représente deux types de quartets vides QV1 et QV2 selon l'invention,

la figure 6 représente en A) un quartet vide imité "QV1" et en B) un quartet vide imité "QV2" lors d'une transmission de paquets,

la figure 7 est un diagramme de signaux du codeur de la figure 3,

les figures 8 et 9 donnent le contenu de la mémoire du codeur de la figure 3,

la figure 10 représente le circuit de choix de la phase du signal d'horloge de la figure 1,

la figure 11 est un diagramme de signaux du circuit de la figure 10,

la figure 12 représente le circuit de reconstitution du signal d'horloge de la figure 1,

la figure 13 est un diagramme de signaux du circuit de la figure 12,

la figure 14 représente le décodeur de la figure 1,

la figure 15 est un diagramme de signaux de la figure 14,

la figure 16 donne le contenu de la mémoire du décodeur de la figure 14,

la figure 17 représente le circuit de détection de perte du signal d'horloge de la figure 1,

la figure 18 est un diagramme de signaux du circuit de la figure 17,

la figure 19 est un diagramme de signaux du décodeur de la figure 14 dans le cas d'une imitation d'un quartet vide.

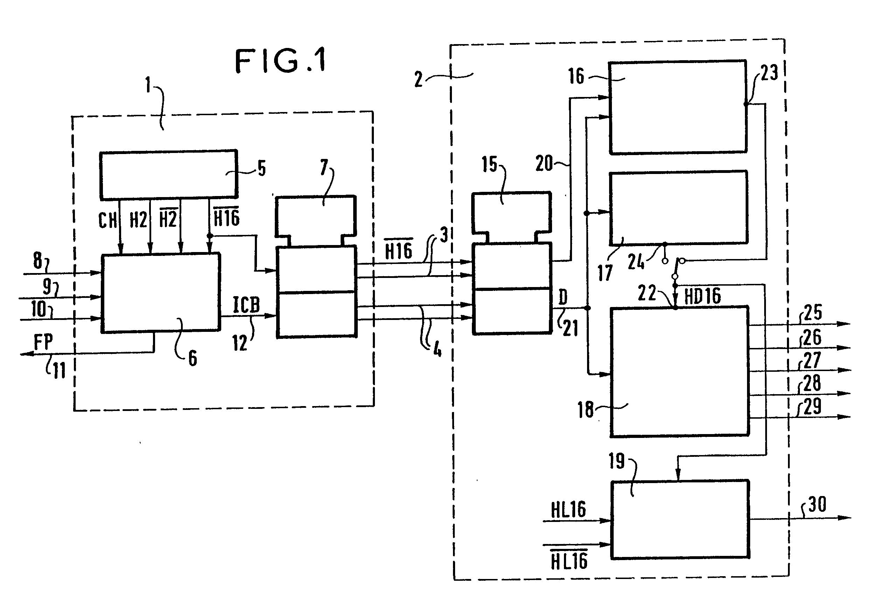

La figure 1 représente schématiquement un dispositif de transmission de paquets de l'invention comprenant un émetteur 1 et un récepteur 2, reliés par une liaison horloge 3 et une liaison de données 4, ces deux liaisons étant bifilaires.

La liaison horloge 3 sert à la transmission du signal ayant par exemple une fréquence de 16 MHz.

L'émetteur 1 comprend une horloge 5, un codeur 6 et un émetteur différentiel 7. Le codeur 6 reçoit de l'horloge un signal de chargement CH, un signal d'horloge $\overline{H16}$, à la fréquence de 16 MHz et deux autres signaux d'horloge H2 et $\overline{H2}$, inverses l'un de l'autre et ayant une fréquence de 2 MHz.

Le codeur est relié en entrée à un circuit, non représenté, qui délivre les informations à transmettre; le codeur est relié à ce circuit par une liaison information 8 qui est une liaison parallèle à quatre lignes, une liaison de parité 9, et une liaison enveloppe 10. La liaison information 8 délivree des quartets constitués chacun par quatre bits 0, 1, 2, 3 en parallèle, la liaison de parité 9 délivre un bit de parité relatif au quartet constitué par les bits 0, 1, 2, 3, et la liaison enveloppe 10 délivre un signal enveloppe de valeur 0 en l'absence d'informations et de la valeur 1 en présence d'informations.

La liaison information 8 délivre en parallèle à l'émetteur quatre bits d'information en code NRZ (non retour à zéro) qui constituent un quartet d'informations. A chaque quartet reçu l'émetteur délivrera, en code Manchester, des données que par commodité on appelera quartet de données, puisque correspondant à un quartet d'informations reçu, et de même durée que celui-ci. De même les silences séparant deux paquets de données seront codés en "quartets" par l'émetteur et appelés quartets vides, ces quartets vides ayant même durée que les quartets de données émis par l'émetteur.

Le codeur est relié en sortie au circuit délivrant les informations à l'émetteur par une liaison faute de parité 11 sur laquelle il délivre un signal faute de parité FP.

L'émetteur différentiel 7 est relié en entrée à l'horloge 5 de laquelle il reçoit le signal d'horloge $\overline{H16}$, et à la sortie du codeur 6 par une ligne 12 par laquelle il reçoit en série des données ICB à transmettre, ces données étant constituées de quartets de données et de quartets vides correspondant aux silences separant deux paquets; l'émetteur différentiel est relié en sortie à la liaison horloge 3 qui transmet le signal d'horloge $\overline{H16}$, et à la liaison de données qui transmet les données ICB reçues du codeur 6.

Le récepteur 2 comprend un récepgeur différentiel 15, un circuit de choix de la phase du signal d'horloge 16, un circuit de reconstitution du signal d'horloge 17, un décodeur 18, et un circuit de détection de perte du signal d'horloge 19.

Le récepteur différentiel 15 est relié en entrée à la liaison horloge 3 et à la liaison de données 4; il est relié en sortie, par une ligne horloge 20, au circuit de choix de la phase du signal d'horloge 16; il est également relié en sortie, par une ligne de données 21 sur laquelle il délivre des données D qui correspondent aux données ICB délivrées par le codeur de l'émetteur, au circuit de choix de la phase du signal d'horloge 16, au circuit de reconstitution du signal d'horloge 17 et au décodeur 18.

Le décodeur 18 a une entrée 22 reliée, soit à la sortie 23 du circuit 16, soit à la sortie 24 du circuit 17. En effet l'émetteur 1 et le récepteur 2 peuvent être reliés par les deux liaisons d'horloge et de données 3 et 4, et dans ce cas le circuit de reconstitution du signal d'horloge 17 est superflu, ou par le seule liaison de données 4, ce qui nécessite alors la reconstitution du signal d'horloge par le circuit 17, le ciruit de choix de la phase du signal d'horloge 16 étant alors superflu. Dans la pratique l'homme de l'art choisit le type de transmission, une seule liaison de données 4 ou deux liaisons, une liaison d'horloge 3 et une liaison de données 4; ce choix étant fait le récepteur ne comporte alors que l'une des circuits 16 ou 17. Bien entendu le récepteur 2 peut comporter les deux circuits 16 et 17, ce qui permet de relier l'émetteur 1 et le récepteur 2 par une seule liaison de données 4 ou par deux liaisons 3 et 4; l'entrée 22 du décodeur est alors reliée, par exemple par strap, un soit à la borne de sortie 23 du circuit 16, soit à la borne de sortie 24 du circuit 17, en fonction du choix du type de transmission entre émetteur et récepteur. L'entrée 22 du décodeur reçoit un signal d'horloge distante HD16 soit du circuit 16, soit du circuit 17.

Le décodeur 18 est relié en sortie à une liaison de sortie de données 25 qui délivre en parallèle les quatre bits de données, à une liaison de sortie de parité 26, à une liaison de sortie enveloppe 27, à une liaison de sortie faute 28, et à une liaison de sortie synchronisation 29.

Le circuit de détection de perte du signal d'horloge 19 est relié à l'entrée 22 du décodeur 18 et reçoit le signal d'horloge distante HD16; le circuit 19 reçoit également des signaux d'horloge locale HL16 et $\overline{HL16}$ d'une horloge locale, non représentée, de fréquence 16 MHz.

Le circuit 19 est relié en sortie à une liaison de sortie perte d'horloge 30.

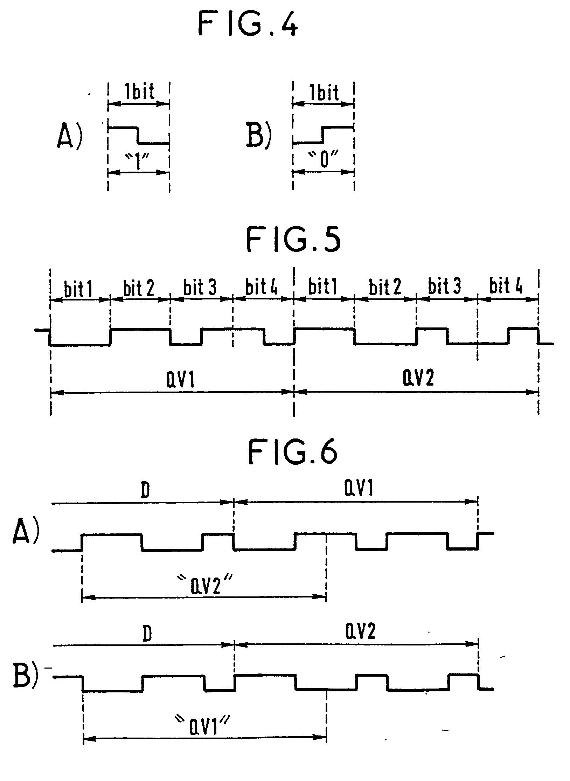

Comme indiqué précédemment l'émetteur délivre des quartets en code Manchester. La figure 4 représente en A) un bit de valeur 1 et en B) un bit de valeur 0, codés selon ce code; chaque bit présente donc une transition médiane, et un bit de valeur 1 est représenté par un niveau 1 pendant une durée de 1/2 bit suivi par un niveau 0 pendant une durée de 1/2 bit, et un bit de valeur 0 est représenté par un niveau 0 pendant une durée de 1/2 bit suivi par un niveau 1 d'un durée de 1/2 bit. En l'absence de données, il est prévu, selon l'invention de transmettre des quartets vides, en utilisant deux configurations alternées de quartets vides, QV1 et QV2, comme représenté figure 5. Dans chacune de ces deux configurations les bits 1 et 2 ne comportent pas de transition médiane, et cette particularité rend les configurations de quartets vides QV1 et QV2 quasi inimitables.

Un quartet QV1 selon la première configuration est constitué par un premier bit de niveau 0, un deuxième bit de niveau 1, un troisième bit de valeur 0 et un quatrième bit de valeur 1; un quartet vide QV2 selon la deuxième configuration est constitué par un premier bit de niveau 1, un deuxième bit de niveau 0, un troisième bit de valeur 1 et un quatrième bit de valeur 0; les troisièmes et quatrièmes bits des quartets vides QV1 et QV2 sont en code Manchester, et ont donc une transition médiane. Les deux configurations de quartets vides QV1 et QV2, figure 5 sont utilisées de telle sorte qu'à la fin d'un paquet et selon la valeur du dernier bit du paquet, donc du dernier quartet de ce paquet, on ait une transition lors du passage à un quartet vide. Ainsi lorsque le dernier bit du paquet a la valeur 1 on utilise le deuxième type de quartet vide QV2 et lorsque le dernier bit du paquet a la valeur 0 on utilise le premier type de quartet vide QV1. Dans ces conditions et selon la composition du dernier quartet du paquet, c'est-à-dire selon les valeurs des quartre bits de ce quartet il peut se présenter une imitation d'un quartet vide QV1 ou QV2. La courbe A de figure 6 représente une imitation d'un quartet vide "QV2", la courbe B représentant une imitation d'un quartet vide "QV1", et l'on observe qu'un quartet vide imité "QV1" ou "QV2" est constitué de 1/2 bits du dernier quartet de données D et de 1/2 bits du quartet vide qui suit ce dernier quartet de données. Ces imitations d'un quartet vide, qui ne sont pas fréquentes puisqui dépendant du dernier quartet d'un paquet, ne sont pas préjudiciables au bon fonctionnement du décodeur, comme cela est précisé plus loin.

Les quartets vides QV1 et QV2 n'ont pas de composante continue, comme c'est également le cas des quartets de données en code Manchester.

Il est possible d'avoir deux configurations de quartets vides inimitables, mais ils n'ont pas l'avantage d'avoir une composante continue nulle. Dans la première configuration, dérivée du premier quartet vide QV1 représenté figure 5, le bit 2 est un bit de valeur 1, avec transition médiane, les autres bits étant identiques; dans la deuxième configuration, dérivée du quartet vide QV2 représenté figure 5, le bit 2 est un bit de valeur 0 avec transition médiane. Ces deux configurations, dérivées des quartets vide QV1 et QV2 de la figure 5 ne seront pas retenues en raison de leur composante continue non nulle.

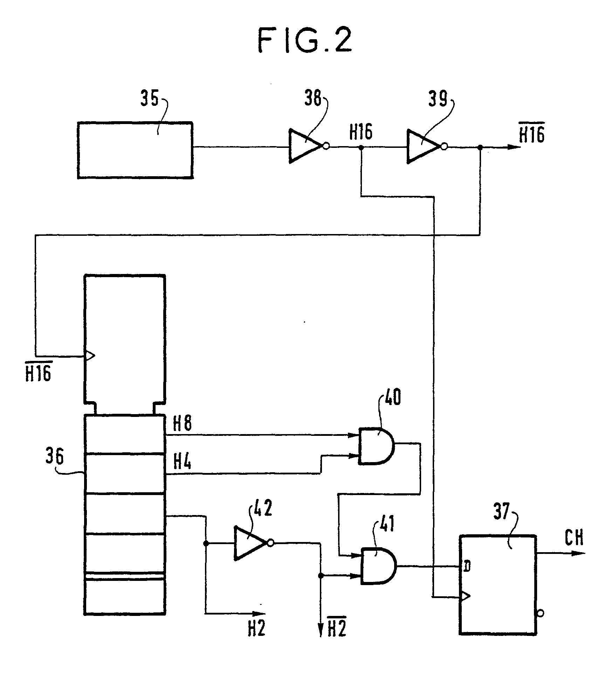

La figure 2 représente l'horloge 5 de la figure 1. L'horloge comprend essentiellement un oscillateur 35, un compteur 36 et un bascule 37 de type D.

La sortie de l'oscillateur est reliée à un inverseur 38 dont la sortie est reliée d'une part à une entrée horloge de la bascule 37 et d'autre part à un inverseur 39; la sortie de l'inverseur 39 est reliée à une entrée horloge du compteur et au codeur 6 de la figure 1.

L'inverseur 38 délivre un signal d'horloge $\overline{H16}$ et l'inverseur 39 délivre un signal d'horloge $\overline{H16}$.

Le compteur 36 délivre sur une première sortie un signal d'horloge H8, de fréquence 8 MHz, sur une deuxième sortie un signal d'horloge H4 de fréquence 4 MHz, et sur une troisième sortie un signal d'horloge H2 de fréquence 2 MHz.

Une porte ET40 à une entrée reliée à la première sortie du compteur, une autre entrée reliée à la deuxième sortie du compteur, et une sortie reliée à une entrée d'une quatre porte ET41 dont une autre entrée est reliée par un inverseur 42 à la troisième sortie du compteur. La sortie de la porte ET41 est reliée à une entrée de donnée de la bascule 37 qui délivre en sortie le signal de chargement CH à destination du codeur 6, de période égale à celle du signal d'horloge H2. La troisième sortie du compteur 36 et la sortie de l'inverseur 42 délivrent respectivement les signaux d'horloge H2 et $\overline{H2}$ à destination du codeur, l'inverseur 39 délivrant également le signal d'horloge $\overline{H16}$ à destination du codeur.

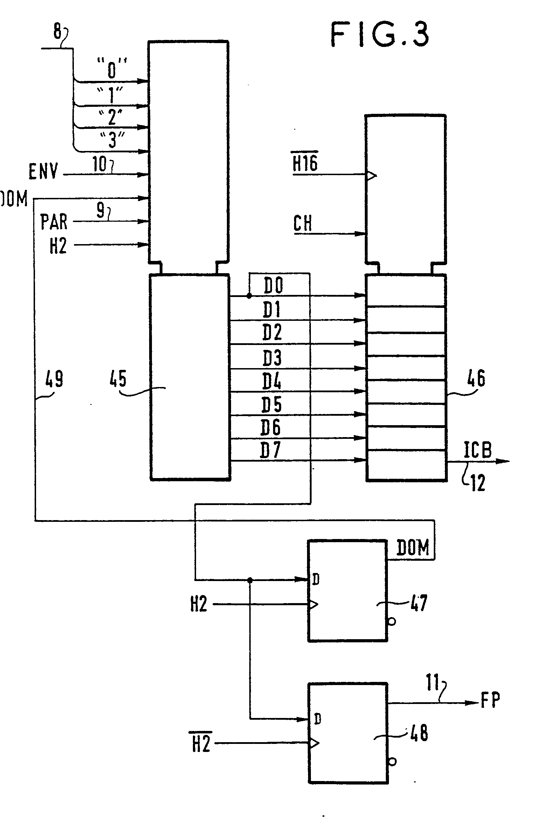

La figure 3 représente le codeur 6 de la figure 1; ce codeur comprend une mémoire morte 45, un registre parallèle-série 46, et deux bascules 47, 48, de type D. La mémoire morte est reliée en entrée à la liaison de données 8 qui délivre en parallèle quatre bits "0", "1", "2", "3", d'un quartet en code NRZ, à la liaison de parité 9 délivrant le signal de parite PAR qui donne la parité de chaque quartet, à la liaison enveloppe 10 délivrant le signal d'enveloppe ENV de valeur 1 pendant toute la durée d'un paquet, à l'horloge 5 de laquelle elle reçoit le signal d'horloge H2, et à une ligne 49 reliée à la sortie de la bascule 47 de laquelle elle reçoit un signal DOM, état du dernier 1/2 bit de chaque quartet de données délivré par la mémoire morte. La mémoire morte 45 a huit sorties parallèles D0 à D7 reliées au registre parallèle-série 46. La sortie D0 de la mémoire morte est également reliée à une entrée données des bascules 47 et 48.

Le registre 46 est relié à l'horloge 5 de laquelle il reçoit le signal d'horloge $\overline{H16}$ et le signal de chargement CH. La sortie série du registre 46 est reliée par la ligne 12 à l'émetteur différentiel 7. La bascule 47 a son entrée horloge reliée à l'horloge 5 de laquelle elle reçoit le signal d'horloge H2; la bascule 48 a son entrée horloge reliée à l'horloge 5 de laquelle elle reçoit le signal d'horloge $\overline{H2}$.

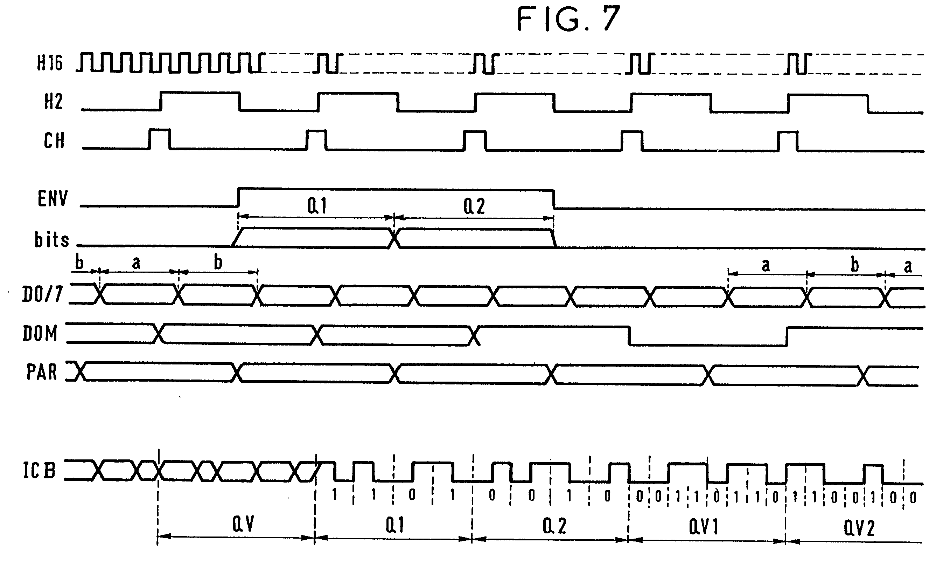

La figure 7 est un diagramme de signaux du codeur 6. On voit sur le diagramme qu'un quartet de données, ou qu'un quartet vide, a une durée égale à une période du signal d'horloge H2 qui divise chaque temps quartet en deux temps; un premier temps lorsque le signal H2 a la valeur 0 et un deuxième temps lorsque le signal H2 a la valeur 1.

Pendant le premier temps, H2=0, la mémoire 45 code:

si le signal enveloppe ENV a la valeur 1, le quartet d'information reçu et délivre les bits correspondants sur les sorties D0 à D7;

si le signal enveloppe ENV a la valeur 0, le quartet de silence QV1 (00110110) si le signal DOM à la valeur 1, ou le quartet silence QV2 (11001001) si le signal DOM a la valeur 0, et délivre les bits correspondants sur les sorties D0 à D7.

Les huit bits, sorties D0 à D7, qui constituent chacun un demi-bit du code Manchester, sont chargés en parallèle dans le registre 46 pour y être décalés au rythme du signal $\overline{H16}$; le bit de la sortie D0 qui correspond au dernier 1/2 bit du quartet délivré par la mémoire, est également mémorisé par la bascule 47 qui délivre le signal DOM. Les huit bits délivrés en série constituent l'information ICB qui est transmise par l'émetteur différentiel 7 au récepteur 2.

Pendant le deuxième temps, H2=1, la mémoire 45 décode le signal de parité PAR qui donne la parité du quartet reçu, et délivre sur la sortie D0 un bit de valeur 0 si la parité est bonne et de valeur 1 si la parité est mauvaise; ce bit est mémorisé par la bascule 48 qui délivre sur la liaison faute de parité 11 le signal FP faute de parité à destination du circuit qui délivre les paquets à l'émetteur.

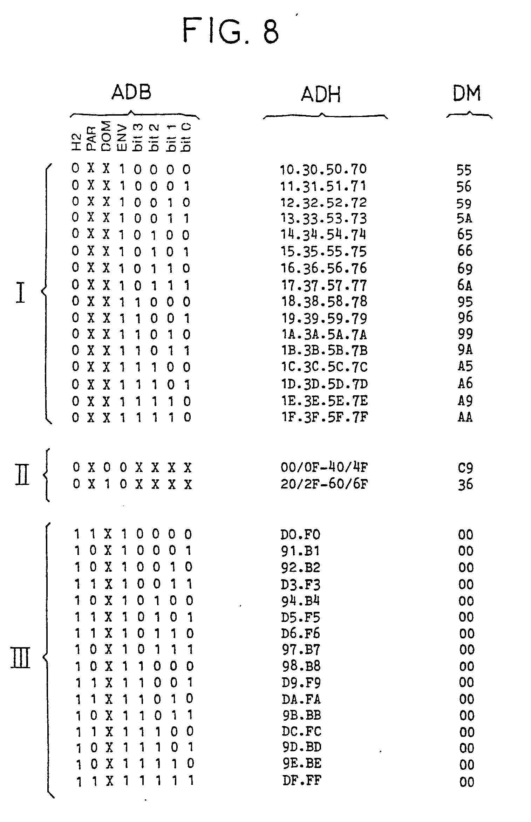

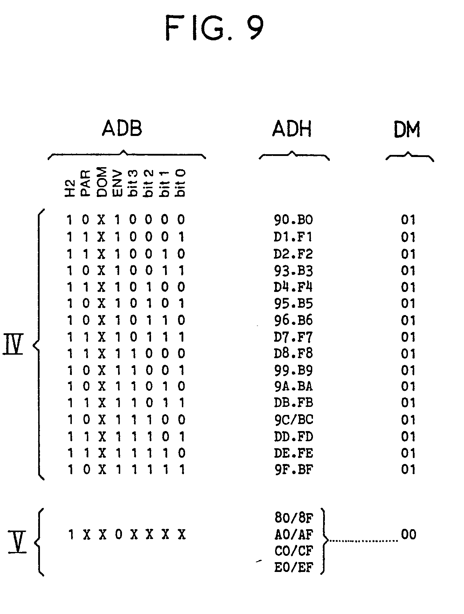

Les figures 8 et 9 donnent le contenu de la mémoire morte 5 du codeur. Dans ces figures la colonne ADB est celle des adresses de la mémoire en binaire; ces adresses sont données par les bits 0, 1, 2, 3, le signal enveloppe ENV, le signal DOM, le signal de parité PAR, et le signal d'horloge H2 à l'entrée de la mémoire morte; la colonne ADH donne l'adresse des mots en code hexadécimal, et la colonne DM donne le contenu des mots en code hexadécimal.

Les ensembles d'adresses I, II, III, IV et V correspondant:

pour l'ensemble I, aux décodage des bits des quartets d'un paquet de données,

pour l'ensemble II au décodage en l'absence de paquet à transmettre, donc pendant le silence qui sépare deux paquets. On remarquera que les adresses correspondantes concernent les quartets vides QV1 et QV2; lorsque le signal DOM a la valeur 1 la mémoire délivre le quartet vide QV1 et lorsque le signal DOM a la valeur 0 la mémoire délivre le quartet vide QV2,

pour l'ensemble III au décodage du signal de parité PAR, lors de la transmission d'un paquet et que la mémoire délivre alors un bit D0 de valeur 0 indiquant que la parité est bonne,

pour l'ensemble IV au décodage du signal de parité PAR lors de la transmission d'un paquet et que la mémoire délivre alors un bit D0 de valeur 1 indiquant que la parité est mauvaise,

pour l'ensemble V au décodage du signal de parité PAR lors des silences (ENV=0) c'est-à-dire en l'absence de paquets.

On remarquera que dans les ensembles I et II, le signal d'horloge H2 a la valeur 0 et que dans les ensembles III, IV, V, ce signal a la valeur 1, ce qui correspond aux deux demi-temps du signal d'horloge H2.

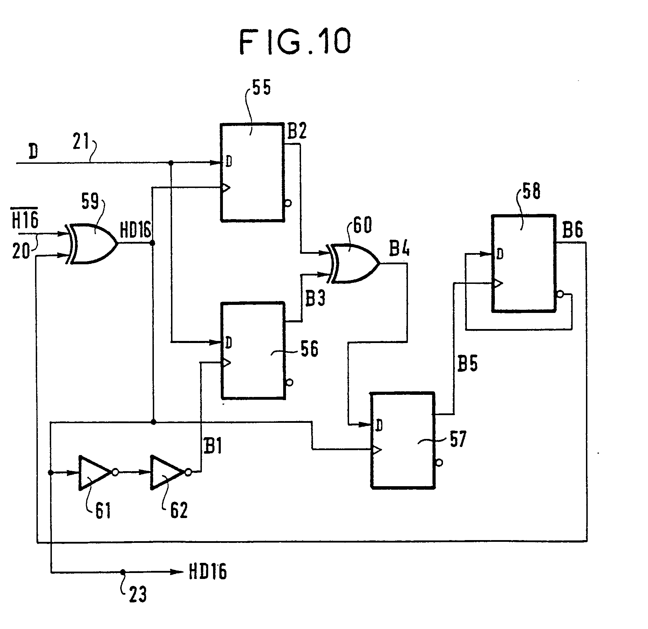

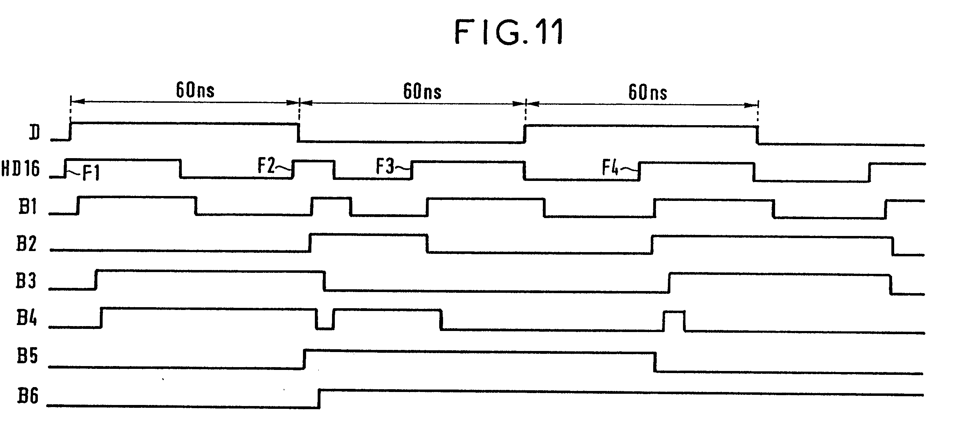

La figure 10 représente le circuit de choix de la phase du signal d'horloge 16 de la figure 1, la figure 11 étant un diagramme de signaux en différents points de la figure 10.

Le circuit de la figure 10 comprend quatre bascules 55, 56, 57, 58, de type D, deux portes OU exclusif 59, 60 et deux inverseurs 61, 62, en série. La porte OU exclusif 59 a une entrée reliée par la ligne horloge 20 à une sortie du récepteur différentiel 15 de la figure 1, et une autre entrée reliée à la sortie directe de la bascule 58. La sortie de la porte OU exclusif 59 délivre un signal d'horloge distant HD16 et est reliée à une entrée horloge les bascules 55 et 57, a l'inverseur 61, et à la borne de sortie 23 du circuit de choix.

La bascule 55 a une entrée de données reliée par la ligne de données 21 à une autre sortie du récepteur différentiel 15 de la figure 1, et une sortie directe reliée à une entrée de la porte OU exclusif 60. La bascule 56 a une entrée de données reliée à la ligne de données 21, une entrée horloge reliée à la sortie de l'inverseur 62 lui même relié à la sortie de l'inverseur 61, et une sortie directe reliée à une autre entrée de la porte OU exclusif 60. La bascule 57 a une entrée de données reliée à la sortie de la porte OU exclusif 60 et une sortie directe reliée à l'entrée horloge de la bascule 58, celle-ci ayant une entrée de données et une sortie inverse reliées entre elles.

La figure 11 est un diagramme de signaux en différents points de la figure 10. Dans cette figure 11 la courbe D est relativ aux données sur la ligne de données 21, la courbe HD16 représente le signal d'horloge distant appliqué aux bascules 55 et 57, la courbe B1 représente le signal d'horloge appliqué à la bascule 56, les courbes B2 et B3 représentent les signaux délivrés par les bascules 55 et 56, respectivement, la courbe B4 représente le signal de sortie de la porte OU exclusif 60, la courbe B5 représente le signal appliqué sur l'entrée horloge de la bascule 58, et la courbe B6 représente le signal délivré par la bascule 58 sur sa sortie directe.

Le circuit de choix de la phase du signal d'horloge est utilisé dans le récepteur lorsque le signal d'horloge et les données sont acheminés sur des supports différents, à partir d'un même émetteur; il y a donc, dans ce cas égalité stricte des rythmes d'émission, mais il n'est pas imposé une mise en phase des signaux émis sur les deux supports, c'est-à-dire la ligne d'horloge 20 et la ligne de données 21. De ce fait le récepteur (figure 1) doit comporter le circuit de choix de la phase du signal d'horloge 16, représenté figure 10, circuit qui doit fonctionner qu'elle que soit la différence de phase entre le signal d'horloge et le signal de données. La porte OU exclusif 59 délivre un signal d'horloge distant HD16 qui permet l'échantillonnage du signal de données D par les bascules 55 et 56, le signal d'horloge HD16 étant appliqué directement à la bascule 55, et à travers les inverseurs 61, 62 à la bascule 56; de ce fait, le signal d'horloge B1 est retardé par rapport au signal d'horloge distant HD16, ce retard étant intoduit par les temps de commutation des inverseurs.

Lorsque les signaux B2 et B3 ont tous les deux la valeur 0, ou tous les deux la valeur 1, le signal B4 a la valeur 0.

Sur la figure 11 le front montant F1 du signal d'horloge distant HD16 se produit lorsque le signal de données D a encore la valeur 0, et le signal B2 reste à zéro, en supposant qu'il avait cette valeur. Le signal B1 a son front montant lorsque le signal de données D à la valeur 1, et le signal B3 passe à la valeur 1. Le signal B4 passe à la valeur 1 puisque les signaux B2 et B3 ont des valeurs différentes. Sur le front montant F2 du signal HD16 appliqué à la bascule 57, le signal B5 passe à la valeur 1 et le signal B6 passe également à la valeur 1 sous l'action du signal B5 appliqué à la bascule 58. Le front montant F2 ayant lieu alors que le signal de données D a la valeur 1, le signal B2 passe a la valeur 1, et les signaux B2 et B3 ayant tous deux la valeur 1, le signal B4 reprend la valeur 0; le signal B1 passant à la valeur 1, avec un décalage par rapport au front F2, le signal B3 passe à la valeur 0, et le signal B4 ne prend la valeur 1. Le signal B6 ayant pris la valeur 1, la porte OU exclusif 59 délivre un signal HD16 de valeur 0. Le signal B6 ayant la valeur 1 le front descendant du signal d'horloge distante HD16 va se traduire en sortie de la porte OU exclusif 59 par un front montant F3 du signal d'horloge distante HD16. Ce front montant fait passer le signal B2 à la valeur 0 puisque le signal de données D a la valeur 0; le front montant du signal B1 ne fait pas charger le signal B3 de valeur puisqu'il avait déjà la valeur 0; les signaux B2 et B3 ayant la valeur 0, le signal B4 passe à la valeur 0. Le signal B5 ne change pas de valeur car le signal B4 avait encore la valeur 1 lors du front montant F3 du signal d'horloge distante HD16 appliqué à la bascule 57.

Lors du front montant F4 du signal d'horloge distante HD16, le signal B5 passe à la valeur 0 puisque le signal B4 a la valeur 0, mais cela ne provoque pas de changement de valeur du signal B6. On voit donc que lorsque les fronts montants F1 et F2 du signal d'horloge distante HD16 (donc du signal d'horloge $\overline{H16}$ provenant de l'émetteur) sont très proches d'une transition du signal de données D le circuit de choix de la phase du signal d'horloge, figure 10, provoque une inversion du signal d'horloge $\overline{H16}$ qu'il reçoit, cette inversion, front F3 de la figure 11, se traduisant par un changement de front du signal d'horloge distante DH16 en sortie de la porte OU exclusif 59, ce signal d'horloge distante HD16 étant délivré par ledit circuit à sa sortie 23.

La transmission séparée du signal d'horloge n'est utilisable que pour une gigue différentielle faible, c'est-à-dire à faible distance, quelques dizaines de mètres entre l'émetteur et le récepteur; pous des distances supérieures on utilise une transmission sur une seule liaison.

Dans le cas où l'émetteur délivre un signal d'horloge $\overline{H16}$ pratiquement en phase avec le signal de données, la gigue acceptable sera de l'ordre de 8 ns, quel que soit le front montant sélectionné, ce chiffre tenant compte des temps de commutation des portes et bascules du circuit représenté figure 10. Il est possible d'admettre une gigue plus important, de l'ordre de 23 ns si l'émetteur délivre un signal d'horloge $\overline{H16}$ en quadrature avec le signal de données. Dans la figure 11, le signal d'horloge distante HD16 en sortie de la porte OU exclusive est pratiquement en phase avec le signal de données D, avant inversion du front montant; ce signal HD16 reproduisant le signal $\overline{H16}$ délivré par l'émetteur.

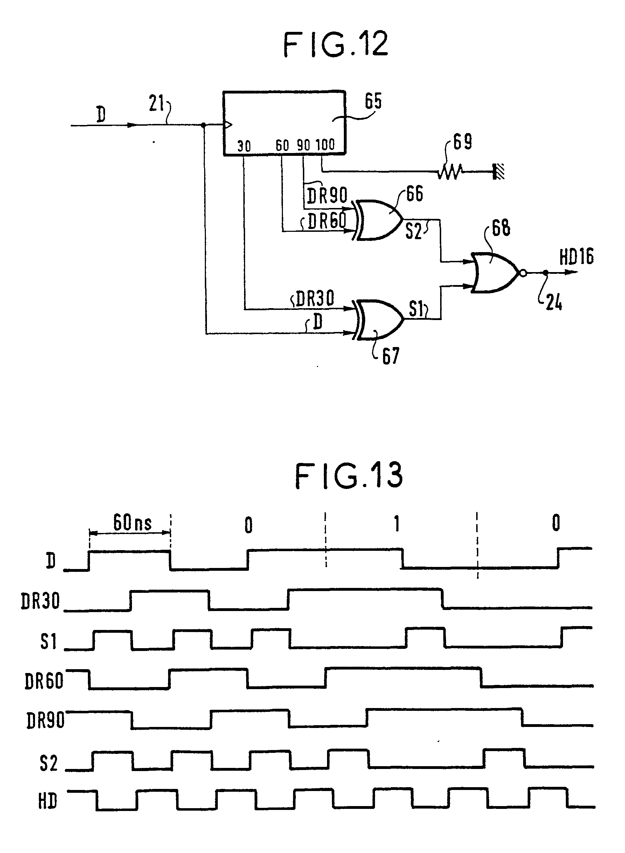

La figure 12 représente le circuit de reconstitution du signal d'horloge 17 de la figure 1, la figure 13 étant un diagramme de signaux en différents points de la figure 12. Le circuit de la figure 12 comporte une ligne à retard 65, deux porte OU exclusif 66, 67, une porte OU-NON 68, et une résistance 69. La ligne à retard 65 est reliée en entrée à la ligne de données 21 (figure 1) par laquelle elle reçoit des données D, et comporte des sorties 30, 60, 90, 100 nanosecondes, le signal reçu étant retardé par pas de 30 ns. La porte OU exclusif 66 est reliée en entrée aux sorties 60 ns et 90 ns de la ligne à retard et en reçoit les signaux DR60 et DR90 qui correspondent au signal de données D retardé de 60 ns et 90 ns. La porte OU exclusif 67 est reliée en entrée à la sortie 30 ns de la ligne à retard et à la ligne de données 21, et reçoit le signal de données D et un signal DR30 qui correspond au signal de données D retardé de 30 ns.

La porte OU-NON 68 est reliée en entrée à la sortie des portes OU exclusif 66, 67, et sa sortie est reliée à la borne de sortie 24 et délivre le signal d'horloge distante HD16. Dans la figure 13 les courbes sont relatives aux signaux en différents points du circuit de la figure 12; les courbes S1 et S2 sont respectivement les signaux sortant des portes OU exclusif 66, 67.

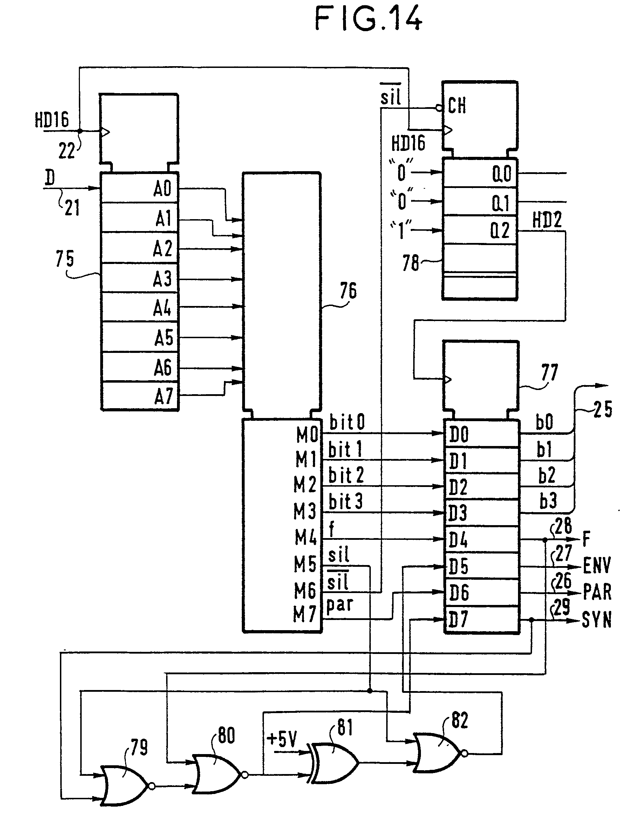

La figure 14 représente le décodeur 18 de la figure 1. Ce décodeur est constitué par un registre d'entrée série-parallèle 75, une mémoire morte 76 d'une capacité de 256 mots de 8 bits, d'un registre de sortie 77 à entrées et sorties parallèles, de trois portes OU-NON 79, 80, 82 et d'une porte OU exclusif 81.

Le registre d'entrée 75 a une entrée horloge reliée à la borne d'entrée 22 (figure 1), elle-même reliée soit à la borne de sortie 23 du circuit de choix de la phase du signal d'horloge 16, soit à la borne de sortie 24 du circuit de reconstitution du signal d'horloge 17; l'entrée horloge du registre 75 reçoit donc le signal d'horloge distante HD16 de l'un des circuits 16 ou 17. Le registre d'entrée 75 a une entrée série reliée à la ligne de données 21, figure 1, de laquelle il reçoit le signal de données D. Le registre d'entrée 75 a huit sorties parallèles A0 à A7 reliées chacune à une entrée de la mémoire morte 76, laquelle a huit sorties parallèles, M0 à M7; les sorties M0 à M3 délivrent les bits 0, 1, 2 et 3 en code NRZ la sortie M4 délivre un signal de faute, f, les sorties M5 et M6 délivrent des signaux de silence sil et $\overline{sil}$, et la sortie M7 délivre un signal de parité, par.

Le registre de sortie 77 a huit entrées parallèles D0 à D7; les entrées D0 à D4 sont reliées aux sorties M0 à M4 de la mémoire morte 76; l'entrée D6 est reliée à la sortie M7 de la mémoire morte; l'entrée D5 est reliée à la sortie de la porte OU-NON 82 de laquelle elle reçoit un signal enveloppe, env; l'entrée D7 est reliée à la sortie de la porte OU-NON 80. Le registre de sortie 77 délivre sur ses huit sorties parallèles, qui correspondant aux entrées D0 à D7, les bits b0, b1, b2, b3, le signal faute F, le signal enveloppe ENV, le signal de parité PAR et un signal de synchronisation SYN. La porte OU-NON 79 a une entrée reliée à la sortie M5 de la mémoire morte et une autre entrée reliée à la sortie du registre de sortie 77 qui délivre le signal de synchronisation SYN. La porte OU-NON 80 a une entrée reliée à la sortie du registre de sortie 77 qui délivre le signal faute F et une autre entrée reliée à la sortie de la porte OU-NON 79. La porte OU exclusif 81 a une entrée reliée à la sortie de la porte OU-NON 80 et une autre entrée reliée à un potentiel positif +5V. La porte OU-NON 82 a une entrée reliée à la sortie de la porte OU exclusif 81 et une autre entrée reliée à la sortie M5 de la mémoire morte 76. Le compteur 78 a une entrée chargement CH reliée à la sortie M6 de la mémoire morte et une entrée horloge reliée à la borne d'entrée 22; le compteur à trois sortie Q0, Q1, Q2 qui délivrent respectivement les signaux d'horloge HD8, HD4, H2 par division par 2, 4, 8 du signal d'horloge distant HD16; la sortie Q2 est reliée à une entrée horloge du registre de sortie 77.

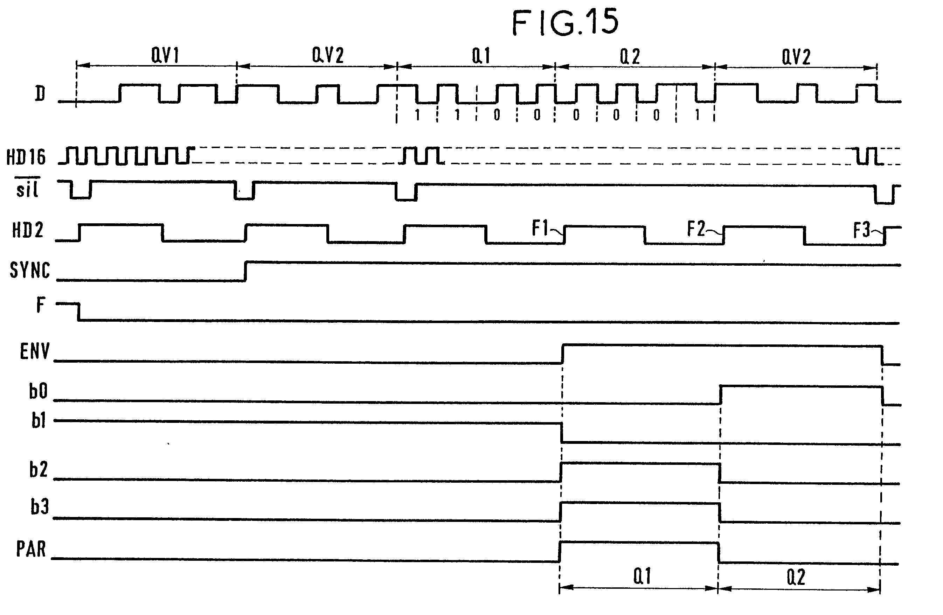

La figure 15 est un diagramme de signaux de la figure 14.

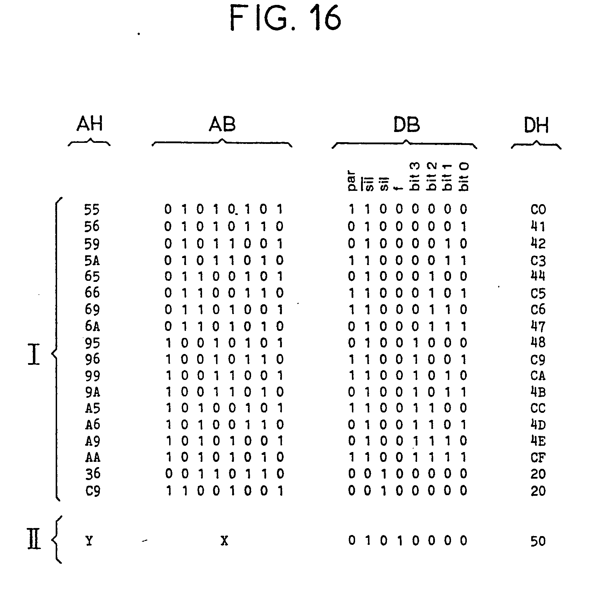

La figure 16 donne le contenu de la mémoire morte 76 du décodeur; les colonnes AH et AB sont celles des adresses de la mémoire morte 76 en hexadécimal pour la colonne AH et en binaire pour la colonne AB; les colonnes DB et DH sont relatives au contenu des mots de la mémoire morte en binaire et en hexadécimal; l'ensemble I regroupe les adresses reçues sans faute. On remarquera que les adresses AH correspondant au contenu DM des mots des ensembles I et II de la figure 8, le contenu de ces mots étant les données délivrées par la mémoire morte de l'émetteur.

Dans le diagramme de la figure 15 on a supposé que le décodeur délivrait un signal faute F et que ce signal disparaissait, passant de la valeur 1 à la valeur 0. Le premier quartet vide QV1 étant délivré par la mémoire morte 76, le signal de silence sil, passe à la valeur 1 à la fin du quartet vide, et le signal de synchronisation SYN prend la valeur 1 sur le front montant du signal d'horloge HD2.

A réception du premier quartet de données Q1 la mémoire morte délivre sur ses sorties M0 à M7 les bits de signaux correspondant au mot adressé par ce premier quartet, et le registre de sortie 77 délivre, sur front positif F1 du signal d'horloge HD2, figure 15, le signal ENV, les bits b0, b1, b2, b3, le signal de parité PAR; le signal faute F reste à la valeur 0 puisque le premier quartet reçu est bon. A réception du deuxième quartet de données Q2, le registre de sortie 77 délivre, sur le front positif F2 du signal d'horloge HD2, les signaux correspondant au mot de la mémoire morte adressé par ce deuxième quartet. Si, comme représenté figure 15, à titre d'exemple, le deuxième quartet est suivi, d'un quartet vide, au front positif F3 du signal d'horloge HD2 le signal enveloppe prend la valeur 0, ainsi que les bits b0, b1, b2, b3; le signal de parité PAR reste à 0. Les quartets de données reçus étant bons, le signal de synchronisation SYN reste à la valeur 1; s'il y avait faute, le signal faute F délivré par le registre de sortie 77 agissant sur la porte OU-NON 80, figure 14, le signal de synchronisation en sortie de ladite porte OU-NON prendrait la valeur 0, de même que le signal de synchronisation SYN en sortie du registre de sortie 77.

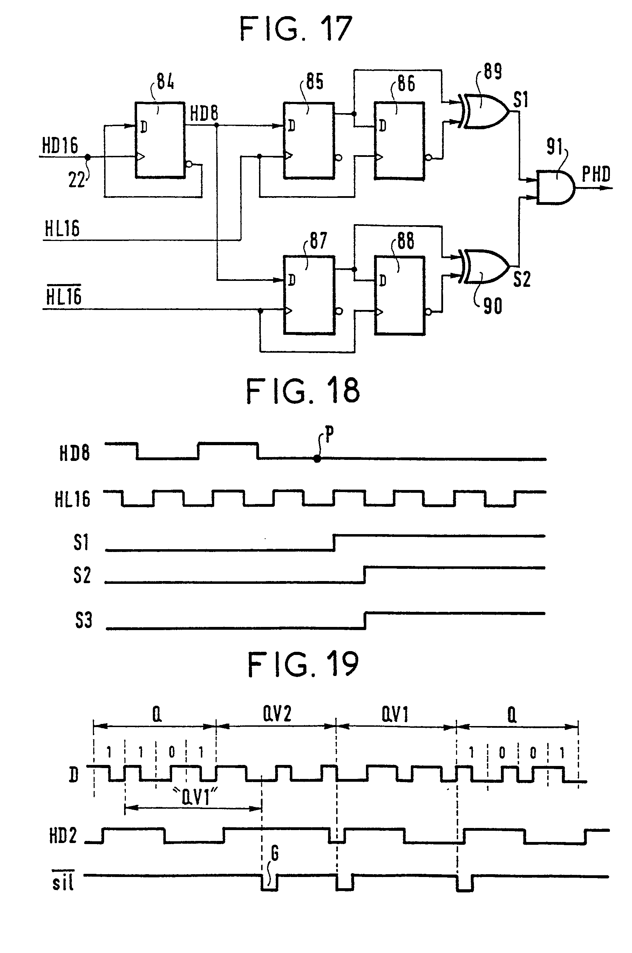

On a indiqué précédemment qu'une imitation des quartets vides n'était pas préjudiciable au bon fonctionnement du récepteur; ceci va être explicité à l'aide de la figure 19 qui représente le signal de données D, le signal d'horloge HD2, et le signal de silence sil délivré par la sortie M6 de la mémoire morte 76 du décodeur de la figure 14, dans le cas d'une imitation d'un quartet vide du premier type, cette imitation étant référence "QV1" figure 19. Le signal de silence sil a toujours la valeur 1 lorsque les données D reçues sont relatives à des quartets de données; il prend la valeur 0, à la fin de chaque quartet vide, pendant une période du signal d'horloge distant HD16, et reprend ensuite la valeur 1. Sur la figure 19 le signal de silence sil passe donc, normalement à la valeur 0 à la fin des quartets vides QV2 et QV1. Dans le cas représenté d'une imitation d'un quartet vide, le signal de silence sil passe aussi en G à la valeur 0, c'est-à-dire à la fin du quartet vide imité "QV1", alors qu'il devrait conserver la valeur 1. Le signal de silence sil étant appliqué à l'entrée charagement du compteur 78, celui-ci est forcé à la valeur 1 chaque fois que le signal de silence sil passe à la valeur 0, ce qui permet, et fonctionnement normal, une bonne synchronisation du signal d'horloge HD2 avec signal de données D. Lorsque le signal de silence sil passe en G à la valeur 0 le compteur 78 est forcé à 1, et le signal d'horloge HD2 reste à la valeur 1; il ne reprend la valeur 0 qu'au bout de quatre périodes du signal d'horloge distant HD16, pour passer ensuite normalement à la valeur 1 à la période suivante. On voit donc qu'une imitation d'un quartet vide se traduit par une perturbation du rapport cyclique du signal d'horloge HD2 au cours d'une période, mais qu'il n'y a pas perturbation des fronts positifs de ce signal d'horloge; comme le registre de sortie 77 est chargé sur les fronts positifs du signal d'horloge HD2, son fonctionnement n'est pas perturbé par une imitation d'un quartet vide. Bien que l'on ait représenté figure 19 une imitation d'un quartet vide QV1, une imitation d'un quartet vide QV2 se traduirait de la même façon par une perturbation du signal de silence sil, donc du signal d'horloge HD2, ces perturbations étant sans conséquence sur le fonctionnement du registre de sortie 77.

La figure 17 représente le circuit de détection de perte du signal d'horloge 19 de la figure 1. Ce circuit comprend cinq bascules 84, 85, 86, 87, 88, de type D, deux portes OU exclusif 89, 90 et une porte ET 91.

La bascule 84 a une entrée horloge reliée à l'entrée 22 du décodeur 18, et reçoit le signal d'horloge distante HD16; sont entrée de données est reliée à sa sortie inverse, et sa sortie directe délivre un signal d'horloge HD8 et est reliée à l'entrée de données de la bascule 85; la bascule 84 fonctionne donc en diviseur par deux. La bascule 85 reçoit sur une entrée horloge un signal d'horloge locale HL16. La bascule 87 a une entrée de données reliée à la sortie directe de la bascule 84 et en reçoit le signal d'horloge HD8, et une entrée horloge qui reçoit un signal d'horloge locale inversé $\overline{HL16}$. L'horloge locale fait partie du récepteur 2 de la figure 1 où elle n'est pas représentée; elle délivre des signaux d'horloge locale HL16 et $\overline{HL16}$, inverse l'un de l'autre, de fréquence 16 MHz, c-est-à-dire de même fréquence que celle de l'horloge 5 de l'émetteur. La bascule 86 a une entrée de données reliée à la sortie directe de la bascule 85 et une entrée horloge qui reçoit le signal d'horloge locale HL16. La porte OU exclusif 89 a une entrée reliée à la sortie directe de la bascule 85 et une entrée reliée à la sortie inverse de la bascule 86. La bascule 88 a une entrée de données reliée à la sortie directe de la bascule 87 et une entrée horloge qui reçoit le signal d'horloge locale inversé $\overline{HL16}$. La porte OU exclusif 90 à une entrée reliée à la sortie directe de la bascule 87 et une entrée reliée à la sortie inverse de la bascule 88. La porte ET91 a une entrée reliée à la sortie de la porte OU exclusif 89 et une entrée reliée à la sortie de la porte OU exclusif 90; sa sortie délivre un signal perte du signal d'horloge PHD.

La figure 18 est un diagramme de signaux de la figure 17. Les bascules 85 et 86 mémorisent une période du signal d'horloge HD8 et sont pilotées par les fronts positifs du signal d'horloge locale HL16. Les bascules 87 et 88 mémorisent une période du signal d'horloge HD8 et sont pilotées par les fronts positifs du signal d'horloge locale inversé $\overline{HL16}$, qui correspondant aux fronts négatifs du signal d'horloge locale HL16. En présence du signal d'horloge HD8 les signaux S1 et S2 en sortie des portes OU exclusif 89, 90 ont la valeur 0. Suite à une perte du signal d'horloge HD8, point P de la figure 18, le signal S1 prend la valeur 1 sur le front positif du signal d'horloge locale HL16, le signal S2 prend la valeur 1 sur le front positif du signal d'horloge inversé $\overline{HL16}$, et la porte ET 91 délivre le signal perte du signal d'horloge PHD.

## Revendications

1. Procédé de codage des silences séparant les paquets dans une transmission de paquets, chaque paquet étant constitué de quartets de données délivrés par un émetteur en code Manchester, à destination d'un récepteur, caractérisé par le fait que l'émetteur délivre, pendant les silences et en alternance, deux types de quartets vides (QV1, QV2) inverses l'un de l'autre et comportant chacun quatre bits de valeurs alternées, et que seuls les troisième et quatrième bits de chaque quartet vide comportent une transition médiane selon le code Manchester, un quartet vide d'un premier type (QV1) ayant un premier bit de niveau 0, un deuxième bit de niveau 1, un troisième bit de valeur 0 et un quatrième bit de valeur 1, un quartet vide d'un deuxième type (QV2) ayant un premier bit de niveau 1, un deuxième bit de niveau 0, un troisième bit de valeur 1 et un quatrième bit de valeur 0.

2. Procédé de codage des silences selon la revendication 1, caractérisé par le fait que l'émetteur délivre, à la suite d'un dernier quartet de données d'un paquet, un quartet vide donnant une transition avec ledit dernier quartet de données, ledit quartet vide étant du premier type lorsque le dernier quartet de données se termine par un bit de valeur 0, et du deuxième type lorsque le dernier quartet de données se termine par un bit de valeur 1.

3. Dispositif de transmission de paquets dans un réseau temporel asynchrone, chaque silence séparant deux paquets étant codé selon le procédé de la revendication 2, dispositif comportant un émetteur (1) et un récepteur (2) reliés par une liaison de données (4) acheminant des quartets de données en code Manchester chaque bit en code Manchester étant constitué par deux demi-bits de valeur différente, et des quartets vides, caractérisé par le fait que l'émetteur comporte une horloge (5), un codeur (6) et un circuit émetteur différentiel (7) relié en sortie à la liaison de données (4), l'horloge délivrant un premier signal d'horloge $\overline{(H16)}$, un deuxième signal d'horloge (H2) obtenu par division par huit du premier signal d'horloge, et un signal de chargement (CH) à chaque début d'une première demi-période du deuxième signal d'horloge (H2), que le codeur comporte une mémoire morte (45), un registre (46) du type parallèle-série piloté par le premier signal d'horloge $\overline{(H16)}$ et recevant sur une entrée chargement le signal de chargement (CH), ledit registre ayant une sortie série reliée au circuit émetteur différentiel (7), une bascule (47) pilotée par le deuxième signal d'horloge (H2), que la mémoire morte est reliée en entrée à une liaison d'information (8) délivrant en parallèle quatre bits en code NRZ constituant un quartet d'informations, et lesdits quatre bits ayant tous la valeur 0 lors des silences, à une liaison de parité (9) délivrant un bit de parité pour chaque quartet d'information, à une liaison enveloppe (10) délivrant un signal de valeur 1 pendant toute la durée d'un paquet, à l'horloge de laquelle elle reçoit le deuxième signal d'horloge (H2), et à la sortie de la bascule (47), que la mémoire morte a huit sorties parallèles (D0 à D7) reliées aux entrées parallèles du registre (46), la première sortie (D0) de la mémoire morte étant également reliée à une entrée de la bascule, la mémoire morte délivrant un quartet de données en code Manchester à chaque quartet d'information reçu et des quartets vides lors des silences, la première sortie D0) de la mémoire morte délivrant un bit dont la valeur correspond au niveau du dernier demi-bit du quartet délivré, que la bascule (47) mémoire ledit bit délivré par ladite première sortie de la mémoire morte et délivre un signal état du dernier demi-bit du quartet, que les autres bits d'un quartet d'information, le bit de parité, le signal enveloppe, le deuxième signal d'horloge et le signal état du dernier demi-bit constituent une adresse de la mémoire morte, que la mémoire morte délivre, pendant une première demi-période du deuxième signal d'horloge (H2), huit bits correspondant à un quartet de données lorsque le signal enveloppe à la valeur 1, à un premier quartet vide lorsque le signal enveloppe a la valeur 0 et le signal état du dernier demi-bit a la valeur 1, et un deuxième quartet vide lorsque le signal enveloppe a la valeur 0 et le signal état du dernier demi-bit a la valeur 0.

4. Dispositif de transmission selon la revendication 3, caractérisé par le fait que le codeur (6) comporte également une deuxième bascule (48) pilotée par le deuxième signal d'horloge inversé $\overline{(H2)}$ et ayant une entrée de données reliée à la première sortie (D0) de la mémoire morte, et que la mémoire morte délivre, pendant une deuxième demi-période du deuxième signal d'horloge (H2), huit bits, la première sortie (D0) de la mémoire morte délivrant à la deuxième bascule un bit de valeur 1 lorsque la parité du quartet d'informations reçu est mauvaise, la deuxième bascule mémorisant ledit bit et délivrant un signal faute de parité (FP) de valeur 1 en cas de mauvaise parité.

5. Dispositif de transmission selon la revendication 3, caractérisé par le fait que l'émetteur (1) et le récepteur (2) sont également reliés par une liaison horloge (3) reliée à une sortie du circuit émetteur différentiel (7) dont une entrée est reliée à l'horloge (5) et en reçoit le premier signal d'horloge $\overline{(H16)}$.

6. Dispositif de transmission selon la revendication 3, caractérisé par le fait que le récepteur comporte un récepteur différentiel (15) reliée par la liaison de données (4) au circuit émetteur différentiel (7), un circuit de reconstitution du signal d'horloge (17) et un décodeur (18), le récepteur différentiel étant relié en sortie par une ligne de données (21) au circuit de reconstitution du signal d'horloge et au décodeur, le décodeur ayant une entrée (22) relié à une sortie (24) du circuit de reconstitution du signal d'horloge qui délivre un premier signal d'horloge distante (HD16), le décodeur étant relié en sortie à une liaison de sortie de données (25), à une liaison de sortie de parité (26), à une liaison de sortie enveloppe (27), à une liaison de sortie faute (28) et à une liaison de sortie synchronisation (29).

7. Dispositif de transmission selon la revendication 5, caractérisé par le fait que le récepteur comporte un récepteur différentiel (15) relié au circuit émetteur différentiel (7) par la liaison horloge (3) et par la liaison de données (4), un circuit de choix de la phase du signal d'horloge (16) et un décodeur (18), le récepteur différentiel ayant une sortie reliée au circuit de choix de la phase du signal d'horloge par une ligne horloge (20) et une autre sortie reliée par une ligne de données (21) au circuit de choix de la phase du signal d'horloge et au décodeur, le décodeur ayant une entrée (22) reliée à une sortie (23) du circuit de choix de la phase du signal d'horloge et en recevant un premier signal d'horloge distante (HD16), le décodeur étant relié en sortie à une liaison de sortie de données (25) à une liaison de sortie de parité (26), à une liaison de sortie enveloppe (27), à une liaison de sortie faute (28) et à une liaison de sortie synchronisation (29).

8. Dispositif de transmission selon l'une des revendications 5 et 6, caractérisé par le fait que le décodeur (18) comporte un registre d'entrée (75) du type série-parallèle, une mémoire morte (76), un registre de sortie (77) du type parallèle-parallèle, un compteur (78), une première (79), une deuxième (80), et une troisième (82) portes OU-NON et une porte OU exclusif (81) qui le registre d'entrée (75) et le compteur (78) ont chacun une entrée horloge reliée à l'entrée (22) du décodeur, que le registre d'entrée (75) a une entrée de données reliée à la ligne de données (21) et huit sorties parallèles reliées à huit entrées parallèles de la mémoire morte (76) pour adressage de ladite mémoire morte, que la mémoire morte a huit sorties parallèles (M0 à M7), une première, une deuxième, une troisième et une quatrième sorties délivrant chacune un bit d'information d'un quartet d'information et étant reliées à une première, une deuxième, une troisième et une quatrième entrées parallèles du registre de sortie (77), une cinquième sortie délivrant un signal faute (f) reliée à une cinquième entrée du registre de sortie, une sixième sortie délivrant un signal de silence (sil) reliée à une entrée de chacune des première et troisième portes OU-NON (79, 82), une septième sortie délivrant un signal de silence inversé $\overline{(sil)}$ reliée à une entrée de chargement (CH) du compteur, et une huitième sortie délivrant un signal de parité (par) et reliée à une septième entrée du registre de sortie (77), que le registre de sortie a huit sorties correspondant chacune à une entrée dudit registre de sortie, les première, deuxième, troisième et quatrième sorties du registre de sortie délivrant les quatre bits du quartet d'information et étant reliées à la liaison de sortie de données (25), la cinquième sortie étant reliée à la liaison de sortie faute (28), la sixième sortie étant reliée à la liaison de sortie enveloppe (27), la septième sortie étant reliée à la liaison de sortie de parité (26), la huitième sortie étant reliée à la liaison synchronisation (29), que la première porte OU-NON (79) a une autre entrée reliée à la liaison de sortie synchronisation (29) et une sortie reliée à une entrée de la deuxième porte OU-NON (80) dont une autre entrée est reliée à la liaison de sortie faute (28), la deuxième OU-NON ayant une sortie reliée à une entrée de la porte OU exclusif (81) et à la huitième entrée du registre de sortie (77), que la porte OU exclusif (81) a une autre entrée portée à un potentiel positif et une sortie reliée à une autre entrée de la troisième porte OU-NON (82) dont une sortie est reliée à la sixième entrée du registre de sortie, et que le compteur est relié en sortie à une entrée horloge du registre de sortie, ledit compteur délivrant un deuxième signal d'horloge distante (HD2) obtenu par division par huit du premier signal d'horloge distante (HD16) reçu par le compteur.

9. Dispositif de transmission selon la revendication 7, caractérisé par le fait que le circuit de choix de la phase du signal d'horloge (16) comporte une première (55), une deuxième (56), une troisième (57) et une quatrième (58) bascules, une première (59) et une deuxième (60) portes OU exclusif, un premier (61) et un deuxième (62) inverseurs en série, que la première porte OU exclusif (59) a une entrée reliée au récepteur différentiel par la ligne horloge (20) et reçoit le premier signal d'horloge ($\overline{H16}$) de l'émetteur, une autre entrée reliée à une sortie directe de la quatrième bascule (58), et une sortie reliée à une entrée horloge des première (55) et troisième (57) bascules, à l'entrée du premier inverseur (61), et à la sortie (23) du circuit de choix de la phase du signal d'horloge, ladite première porte OU exclusif délivrant un premier signal d'horloge distante (HD16), que les première (55) et deuxième (56) bascules ont chacune une entrée de données reliée au récepteur différentiel par la ligne de données (21), que le deuxième inverseur (62) est relié en sortie à une entrée horloge de la deuxième bascule (56), que la deuxième porte OU exclusif (60) a une entrée reliée à une sortie directe de la première bascule (55), une autre entrée reliée à une sortie directe de la deuxième bascule (56) et une sortie reliée à une entrée de données de la troisième bascule (57), et que la quatrième bascule (58) a une entrée horloge reliée à une sortie directe de la troisième bascule, et une entrée de données et une sortie inverse reliées entre elles.

**Patentansprüche**

1. Verfahren zum Kodieren von Pausen zwischen Datenpaketen bei der Übertragung von Datenpaketen, wobei jedes Paket aus Datenhalbbytes besteht, die von einem Sender in Manchesterkode an einen Empfänger übermittelt werden, dadurch gekennzeichnet, daß der Sender während der Pausen und abwechselnd zwei zueinander komplementäre Typen von leeren Halbbytes (QV1, QV2), je bestehend aus vier Bits mit wechselnden Werten, sendet und daß nur das dritte und das vierte Bit jedes leeren Halbbytes in der Mitte einen Übergang entsprechend dem Manchesterkode aufweisen wobei ein leeres Halbbyte des ersten Typs (QV1) eine erstes Bit mit Wert 0, ein zweites Bit mit Wert 1, ein drittes Bit mit Wert 0 und ein viertes Bit mit Wert 1, und ein leeres Halbbyte des zweiten Typs (QV2) ein erstes Bit mit Wert 1, ein zweites Bit mit Wert 0, ein drittes Bit mit Wert 1 und ein viertes Bit mit Wert 0 besitzt.

2. Verfahren zum Kodieren der Pausen nach Anspruch 1, dadurch gekennzeichnet, daß der Sender im Anschluß an ein letztes Datenhalbbyte eines Paketes ein leeres Halbbytepaket übermittelt, welches einen Übergang mit dem letzten Datenhalbbyte herstellt, wobei dieses leere Halbbyte dem ersten Datentyp angehört, wenn das letzte Datenpaket mit einem Bit des Wertes 0 endet, und dem zweiten Typ, wenn das letzte Datenhalbbyte mit einem Bit des Werts 1 endet.

3. Einrichtung zur übertragung von Datenpaketen in einem asynchronen Zeitmultiplexnetz, wobei jede zwei Datenpakete trennende Pause gemäß dem Verfahren nach Anspruch 2 kodiert ist und die Einrichtung einen Sender (1) und einen Empfänger (2) aufweist, die über eine Datenverbindung (4) miteinander verbunden sind, welche Datenhalbbytes im Manchesterkode, wobei jedes Manchesterkodebit aus zwei Halbbits mit unterschiedlichem Wert besteht, und leere Halbbytes übermittelt, dadurch gekennzeichnet, daß der Sender einen Taktgeber (5), einen Kodierer (6) und eine Differentialsendeschaltung (7) aufweist, deren Ausgang an die Datenverbindung (4) angeschlossen ist, wobei der Taktgeber ein erstes Taktsignal ($\overline{H16}$), ein zweites, durch Achtelung des ersten Taktsignals gewonnenes Taktsignal (H2) und ein Ladesignal (CH) an jedem Anfang einer ersten Halbperiode des zweiten Taktsignals (H2) liefert, daß der Kodierer einen Festspeicher (45), ein durch das erste Taktsignal ($\overline{H16}$) gesteurtes Parallel-Serienregister (46), welches am Ladeeingang das Ladesignal (CH) empfängt, wobei das Register mit einem Serienausgang an die Differentialsendeschaltung (7) angeschlossen ist und ein Flip-Flop (47) aufweist, das vom zweiten Taktsignal (H2) gesteuert wird, daß der Festspeicher eingangsseitig an eine Dateninformationsverbindung (8), welche parallel vier NRZ-kodierte, ein Informationshalbbyte bildende Bits liefert, wobei diese vier Bits sämtlich während der Pausen den Wert 0 besitzen, an eine Paritätsverbindung (9), welche für jedes Informationshalbbyte ein Paritätsbit liefert, an eine Hüllkurvenverbindung (9), welche während der gesamten Dauer eines Datenpakets ein Signal mit Wert 1 liefert, an den Taktgeber, von welchem er das zweite Taktsignal (H2) empfängt, und an den Ausgang des Flip-Flops (47) angeschlossen ist, daß der Festspeicher acht parallele, an die parallelen Eingänge des Registers (46) angeschlossene Ausgänge (D0 bis D7) besitzt, wobei der erste Ausgang (D0) des Festspeichers auch an einen Eingang des Flip-Flops angeschlossen ist und der Festspeicher für jedes empfangene Informationspaket ein Datenhalbbyte in Manchesterkode sowie während der Pausen leere Halbbytes liefert, und wobei der erste Ausgang (D0) des Festspeichers ein Bit liefert, dessen Wert dem Pegel des letzten Halbbits des gelieferten Halbbytes entspricht, daß das Flip-Flop (47) das vom ersten Ausgang des Festspeichers gelieferte Bit speichert und ein Statussignal des letzten Halbbits des Halbbytes liefert, daß die vier Bits eines Informationshalbbytes, das Prioritätsbit, da Hüllsignal, das zweite Taktsignal und das Steuerssignal des letzten Halbbits eine Adresse des Festspeichers bilden, daß der Festspeicher während einer ersten Halbperiode des zweiten Taktsignals (H2) acht Bits liefert, welche einem Datenhalbbyte entsprechen, wenn das Hüllkurvensignal den Wert 1 besitzt, einem ersten leeren Halbbyte entsprechen, wenn das Hüllkurvensignal den Wert 0 und das Statussignal des letzten Halbbits den Wert 1 bestizt, und einem zweiten leeren Halbbyte entsprechen, wenn das Hüllkurvensignal den Wert 0 und das Statussignal des letzten Halbbits den Wert 0 bestitzt.

4. Übertragungseinrichtung nach Anspruch 3, dadurch gekennzeichnet, daß der Kodierer (6) weiter ein zweites vom invertierten zweiten Taktsignal ($\overline{H2}$) gesteuertes Flip-Flop (48) aufweist, das mit eineim Dateneingang an den letzten Ausgang (D0) des Festspeichers angeschlossen ist, und daß der Festspeicher während einer zweiten Halbbperiode des zweiten Taktsignals (H2) acht Bits liefert, wobei der erste Ausgang (D0) des Festspeichers an das zweite Flip-Flop ein Bit mit Wert 1 enlegt, wenn die Parität des empfangenen Informationshalbbytes ungerade ist, und das zweite Flip-Flop das betreffende Bit speichert und im Falle ungerader Parität ein Paritätsfehlersignal (FP) liefert.

5. Übertragungseinrichtung nach Anspruch 3, dadurch gekennzeichnet, daß der Sender (1) und der Empfänger (2) weiter über eine Taktsignalverbindung (3) an einen Ausgang der Differentialsendeschaltung (7) angeschlossen sind, von der ein Eingang mit dem Taktgeber (5) verbunden ist und von diesem das erste Taktsignal ($\overline{H16}$) empfängt.

6. Übertragungseinrichtung nach Anspruch 3, dadurch gekennzeichnet, daß der Empfänger einen Differentialempfänger (15), der über die Datenverbindung (4) mit der Differentialsendeschaltung (7) verbunden ist, eine Taktsignalwiederherstellungsschaltung (17) und einen Dekodierer (18) aufweist, wobei der Differentialempfänger ausgangsseitig über eine Datenleitung (21) an die Taktsignalwiederherstellungsschaltung und an den Dekodierer angeschlossen ist und wobei der Dekodierer mit einem Eingang (22) an einen Ausgang (24) der Taktsignalwiederherstellungsschaltung angeschlossen ist, welche ein erstes Ferntaktsignal (HD16) liefert, und mit dem Ausgang an eine Datenausgangsverbindung (25), an eine Paritätsausgangsverbindung (26), an eine Hüllkurvenausgangsverbindung (27) an eine Falschsignalausgangsverbindung (28) und an eine Synchronisationsausgangsverbindung (29) angeschlossen ist.

7. Übertragungseinrichtung nach Anspruch 5, dadurch gekennzeichnet, daß der Empfänger einen Differentialempfänger (15), der über die Taktsignalverbindung (3) und die Datenverbindung (4) mit der Differentialsendeschaltung (7) verbunden ist, eine Taktsignal-Phasenwahlschaltung (16) und einen Dekodierer (18) aufweist, wobei der Differentialempfänger mit einem Ausgang über eine Taktsignalleitung (20) an die Taktsignal-Phasenwahlschaltung (16) und mit einem anderen Ausgang über eine Datenleitung (21) mit der Taktsignal-Phasenwahlschaltung sowie mit dem Dekodierer verbunden ist, wobei der Dekodierer mit einem Eingang (22) an einen Ausgang (23) der Taktsignalphasenwahlschaltung angeschlossen ist und ein erstes Ferntaktsignal (HD16) empfängt, und wobei der Dekodierer ausgangsseitig an eine Datenausgangsverbindung (25), eine Paritätsausgangsverbindung (26), eine Hüllkurvenausgangsverbindung (27), eine Falschausgangsverbindung (28) und an eine Synchronisationsausgangsverbindung (29) angeschlossen ist.

8. Übertragungseinrichtung nach einem der Ansprüche 5 und 6, dadurch gekennzeichnet, daß der Dekodierer (18) ein Serien-Parallel-Eingangsregister (75), einen Festspeicher (76), eine Parallel-Parallel-Register (77), einen Zähler (78), ein erstes (79), ein zweites (80) und ein drittes (82) NOR-Tor und ein Exklusiv-ODER-Tor (81) aufweist, daß das Eingangsregister (75) und er Zähler (78) jeweils mit einem Takteingang an den Eingang (22) des Dekodierers angeschlossen sind, daß das Eingangsregister (75) mit einem Dateneingang an die Datenleitung (21) und mit acht Parallelausgängen an acht Paralleleingänge des Festspeichers (76) zum Adressieren des Festspeichers angeschlossen ist, daß der Festspeicher acht Parallelausgänge (M0 bis M7) besitzt, von denen ein erster, zweiter, dritter und vierter Ausgang jeweils ein Informationsbit eines Informationshalbbytes liefert und jeweils mit einem ersten, zweiten, dritten und vierten Paralleleingang des Ausgangsregisters (77) verbunden ist, und von denen ein fünfter an einen fünften Eingang des Ausgangsregisters angeschlossener Ausgang ein Falschsignal (f), ein sechster an einen Eingang jeweils des ersten und dritten NOR-Tores (79, 82) angeschlossener Ausgang ein Pausensignal (sil), ein siebenter an einen Ladeeingang (CH) des Zählers angeschlossener Ausgang ein komplementäres Pausensignal ($\overline{sil}$), und ein achter an einen siebenten Eingang des Ausgangsregisters (77) angeschlossener Ausgang ein Paritätssignal (par) liefert, daß das Ausgangsregister acht Ausgänge besitzt, von denen jeder einem Eingang dieses Ausgangsregisters entspricht, wobei die Ausgänge eins, zwei, drei und vier die vier Bits des Informationshalbbytes liefern und mit der Datenausgangsverbindung (25) verbunden sind, während der fünfte Ausgang an die Falschsignalausgangsverbindung (28), der sechste Ausgang an die Hüllkurvenausgangsverbindung, der siebente Ausgang an die Paritätsausgangsverbindung (26) und der achte Ausgang an die Synchronisationsverbindung (29) angeschlossen ist, daß das erste NOR-Tor (79) mit einem weiteren Eingang an die Ausgangssynchronisationsverbindung (29) und mit einem Ausgang an einen Eingang des zweiten NOR-Tors (80) angeschlossen ist, dessen anderer Eingang mit der Falschsignalausgangsverbindung (28) verbunden ist, wobei ein Ausgang des zweiten NOR-Tores mit einem Eingang des Exklusiv-ODER-Tors (81) und mit dem achten Eingang des Ausgangsregisters (77) verbunden ist, daß das Exklusiv-ODER-Tor (81) mit einem anderen Eingang an ein positives Potential gelegt und mit einem Ausgang an einem anderen Eingang des dritten NOR-Tores (82) angeschlossen ist, dessen Ausgang an den sechsten Eingang des Ausgangsregister angeschlossen ist, und daß der Zähler mit dem Ausgang an einem Takteingang des Ausgangsregisters angeschlossen ist, wobei der Zähler ein zweites Ferntaktsiganl (HD2) liefert, das durch Achtelung des vom Zähler empfangenen Ferntaktsignals (HD16) gewonnen wird.

9. Übertragungseinrichtung nach Anspruch 7, dadurch gekennzeichnet, daß die Taktsignal-Phasenwahlschaltung (16) ein erstes (55), zweites (56), drittes (57) und viertes Flip-Flop (58), ein erstes (59) und ein zweites Exklusiv-ODER-Tor (60), und einen ersten (61) und zweiten Inverter (62) in Serie aufweist, daß das erste Exklusiv-ODER-Tor (59) mit einem Eingang über die Taktsignalleitung (20) an den Differentialempfänger angeschlossen ist und das erste Taktsignal ($\overline{H16}$) des Senders empfängt, mit einem anderen Eingang an einen direkten Ausgang des vierten Flip-Flops (58), und mit einem Ausgang an einen Takteingang des ersten (55), und des dritten Flip-Flops (57), an den Eingang des ersten Inverters (61) und an den Ausgang (23) der Taktsignal-Phasenwahlschaltung angeschlossen ist, wobei das erste Exclusiv-ODER-Tor ein erstes Fernktaksignal (HD16) liefert, daß das erste (55) und zweite Flip-Flop (56) jeweils mit einem Dateneingang über die Datenleitung (21) mit dem Differentialempfänger verbunden sind, daß der zweite Inverter (62) ausgangsseitig an einem Takteingang des zweiten Flip-Flops angeschlossen ist, daß das zweite Exklusiv-ODER-Tor (60) mit einem Eingang an den direkten Ausgang des ersten Flip-Flops (55), mit einem zweiten Eingang an den direkten Ausgang des zweiten Flip-Flops (56) und mit einem Ausgang an einem Dateneingang des dritten Flip-Flops (57) angeschlossen ist, und daß das vierte Flip-Flop (58) mit einem Takteingang an einen direkten Ausgang des dritten Flip-Flops (57) angeschlossen ist und einen Dateneingang sowie einen komplementären Ausgang besitzt, die miteinander verbunden sind.

**Claims**

1. A method of encoding silences separating packets in a packet transmission system in which each packet comprises half-bytes of data delivered by a Manchester code transmitter and transmitted to a receiver, characterized in that the transmitter delivers, during the silences and alternately, two mutually inverse types of empty half-bytes (QV1, QV2) which each comprise four bits of alternating values and only the third and fourth bits of each empty half-byte comprises a median transition according to the Manchester code, an empty half-byte of a first type (QV1) having a first bit of level 0, a second bit of level 1, a third bit of value 0 and a fourth bit of value 1, an empty half-byte of a second type (QV2) having a first bit of level 1, a second bit of level 0, a third bit of value 1 and a fourth bit of value 0.

2. A method of encoding silences in accordance with Claim 1, characterized in that the transmitter delivers, after a first half-byte of data of a packet, an empty half-byte giving a transition with said last data half-byte, said empty half-byte being of the first type when the last data half-byte ends with a bit of value 0, and of the second type when the last data half-byte ends with a bit of value 1.

3. A device for transmitting packets in an asynchronous time-division network, each silence which separates two packets being encoded according to the method of Claim 2, the device comprising a transmitter (1) and a receiver (2) connected by a data link (4) conveying on the one hand data half-bytes in Manchester code of which each bit consists of two half-bits of different value, and on the other hand empty half-bytes, characterized in that the transmitter comprises a clock (5), an encoder (6) and a differential transmitter circuit (7) with its output connected to the data link (4), the clock delivering a first clock signal ($\overline{H16}$), a second clock signal (H2) obtained by dividing the first clock signal by eight, and a load signal (CH) at the beginning of each first half period of the second clock signal (H2), that the encoder comprises a read-only memory (45), a register (46) of the parallel-serial type driven by the first clock signal ($\overline{H16}$) and receiving on a load input the load signal (CH), said register having a serial output connected to the differential transmitter circuit (7), a bistable (47) driven by the second clock signal (H2), that the read-only memory is input-connectsd to an information link (8) delivering in parallel four bits in NRZ code constituting one information half-byte, said four bits all having the value 0 during the silences, to a parity link (9) delivering a parity bit for each information half-byte, to an envelope link (10) delivering a signal of value 1 throughout the duration of a packet, to the clock from which it receives the second clock signal (H2), and to the output of the bistable (47), that the read-only memory has eight parallel outputs (D0 to D7) connected to the parallel inputs of the register (46), the first output (D0) of the read-only memory being also connected to an input of the bistable, the read-only memory delivering a data half-byte in Manchester code for each information half-byte received and empty half-bytes during silences, the first output (D0) of the read-only memory delivering a bit whose value corresponds to the level of the last half-bit of the half-byte delivered, that the bistable (47) memorizes said bit delivered by said first output of the read-only memory and delivers a signal reflecting the state of the last half-bit of the half-byte, that the four bits of an information half-byte, the parity bit, the envelope signal, the second clock signal and the signal reflecting the state of the last half-bit constitute a read-only memory address, that the read-only memory delivers during a first half-period of the second clock signal (H2) eight bits corresponding to a data half-byte when the envelope signal has the value 1, corresponding to a first empty half-byte when the envelope signal has the value 0 and the signal reflecting the state of the last half-bit has the value 1, and a second empty half-byte when the envelope signal has the value 0 and the signal reflecting the state of the last half-bit has the value 0.

4. A transmission device according to Claim 3, characterized in that the encoder (6) further comprises a second bistable (48) driven by the complemented second clock signal ($\overline{H2}$) and having a data input connected to the first ouptut (D0) of the read-only memory, and that the read-only memory delivers eight bits during a second half-byte of the second clock signal (H2), the first

output (D0) of the read-only memory delivering to the second bistable a bit of value 1 when the parity of the information half-byte reveived is incorrect, the second bistable memorizing said bit and delivering a parity error signal (FP) of value 1 in response to an incorrect parity.

5. A transmission device according Claim 3, characterized in that the transmitter (1) and the receiver (2) are also connected by a clock link (3) connected to an output of the differential transmitter circuit (7) of which an input is connected to the clock (5) to receive from it the first clock signal $(\overline{H16})$.

6. A transmission device according to Claim 3, characterized in that the receiver comprises a differential receiver (15) connected by the data link (4) to the differential transmitter circuit (7), a circuit (17) for reconstituting the clock signal and a decoder (18), the differential receiver having its output connected by a data line (21) to the clock signal reconstituting circuit and to the decoder, the decoder having an input (22) connected to an output (24) of the clock signal reconstituting circuit which delivers a first remote clock signal (HD16), the decoder having its output connected to a data output link (25), to a parity output link (26), to an envelope output link (27), to an error output link (28) and to a synchronization output link (29).

7. A transmission device according to Claim 5, characterized in that the receiver comprises a differential receiver (15) connected to the differential transmitter circuit (7) by the clock link (3) and the data link (4), a circuit (16) for choosing the phase of the clock signal, and a decoder (18), an output of the differential receiver being connected via a clock line (20) to the circuit for choosing the phase of the clock signal and another output of said differential receiver being connected via a data line (21) to the circuit for choosing the phase of the clock signal and to the decoder, the decoder having an input (22) connected to an output (23) of the circuit for choosing the phase of the clock signal and receiving from it a first remote clock signal (HD16), the decoder having its output connected to a data output link (25), to a parity output link (26), to an envelope output link (27), to an error output link (28) and to a synchronization output link (29).

8. A transmission device according to one of Claims 5 and 6, characterized in that the decoder (18) comprises a serial-parallel type input register (75), a read-only memory (76), a parallel-parallel type output register (77), a counter (78), first (79), second (80) and third NOR gates (82) and an exclusive-OR gate (81), that the input register (75) and the counter (78) each have a clock input connected to the input (22) of the decoder, that the input register (75) has a data input connected to the data line (21) and eight parallel outputs connected to eight parallel inputs of the read-only memory (76) for addressing said read-only memory, that the read-only memory has eight parallel outputs (M0 to M7), first, second, third and fourth outputs each delivering one information bit of an information half-byte and being connected to first, second, third and fourth parallel inputs of the output register (77), a fifth output which delivers an error signal (f) being connected to a fifth input of the output register, a sixth output which delivers a silence signal (sil) being connected to an input of each of the first and third NOR (79, 82) gates, a seventh output which delivers a complemented silence signal $(\overline{sil})$ being connected to a loading input (CH) of the counter, and an eighth output which delivers a parity signal (par) being connected to the seventh input of the output register (77), the output register has eight outputs each corresponding to one input of said output register, the first, second, third and fourth outputs of the output register delivering the four bits of the information half-bytes and being connected to the data output link (25), the fifth output being connected to the error output link (28), the sixth output being connected to the envelope output link (27), the seventh output being connected to the parity output link (26), the eighth output being connected to the synchronization link (29), that the first NOR gate (79) has another input connected to the synchronization output link (29) and an output connected to an input of the second NOR gate (80) another input of which is connected to error output link (28), the second NOR gate having an output connected to an input of an exclusive-OR gate (81) and to the eighth output of the input register (77), that the exclusive-OR gate (81) has another input held at a positive potential and an output connected to another input of the third NOR gate (82) of which an output is connected to the sixth input of the output register, and that the counter has its output connected to a clock input of the output register, said counter delivering a second remote clock signal (HD2) obtained by dividing by eight the first remote clock signal (HD16) received by the counter.

9. A transmission device according to Claim 7, characterized in that the circuit (16) for choosing the phase of the clock signal comprises first (55), second (56), third (57) and fourth bistables (58), first (59) and second exclusive-OR gates (60), first (61) and second converters (62) connected in series, that the first exclusive-OR gate (59) has an input connected to the differential receiver by the clock line (20) and receives the first clock signal $(\overline{H16})$ from the transmitter, another input connected to a direct output of the fourth bistable (58) and an output connected to a clock input of the first (55) and third bistables (57), to the input of the first inverter (61) and to the output (23) of the circuit for choosing the phase of the clock signal, said first exclusive-OR gate delivering a first remote clock signal (HD16), that the first (55) and second bistables (56) each have a data input connected to the differential receiver by the data line (21), that the second inverter (62) has its output connected to a clock input of the second bistable (56), the second exclusive-OR gate (60) has one input connected to a direct output of the first bistable (55), another input connected to a direct output of the second bistable (56) and an output connected to a data input of the third bistable (57), and that the fourth bistable (58) has a clock input connected to a direct output of the third bistable and a data input and a complemented output connected to each other.

# FIG.1

EP 0 211 438 B1

# FIG.2

# FIG.3

# FIG.4

A)

1bit

"1"

B)

1bit

"0"

# FIG.5

| bit 1 | bit 2 | bit 3 | bit 4 | bit1 | bit 2 | bit 3 | bit 4 |

QV1

QV2

# FIG.6

A)

D

QV1

"QV2"

B)

D

QV2

"QV1"

4

# FIG. 7

EP 0 211 438 B1

# FIG. 8

| ADB | | | | | | | | ADH | DM |
|---|---|---|---|---|---|---|---|---|---|
| H2 | PAR | DOM | ENV | bit 3 | bit 2 | bit 1 | bit 0 | | |

| H2 | PAR | DOM | ENV | bit 3 | bit 2 | bit 1 | bit 0 | ADH | DM |
|---|---|---|---|---|---|---|---|---|---|
| 0 | X | X | 1 | 0 | 0 | 0 | 0 | 10.30.50.70 | 55 |
| 0 | X | X | 1 | 0 | 0 | 0 | 1 | 11.31.51.71 | 56 |
| 0 | X | X | 1 | 0 | 0 | 1 | 0 | 12.32.52.72 | 59 |
| 0 | X | X | 1 | 0 | 0 | 1 | 1 | 13.33.53.73 | 5A |
| 0 | X | X | 1 | 0 | 1 | 0 | 0 | 14.34.54.74 | 65 |
| 0 | X | X | 1 | 0 | 1 | 0 | 1 | 15.35.55.75 | 66 |
| 0 | X | X | 1 | 0 | 1 | 1 | 0 | 16.36.56.76 | 69 |
| 0 | X | X | 1 | 0 | 1 | 1 | 1 | 17.37.57.77 | 6A |
| 0 | X | X | 1 | 1 | 0 | 0 | 0 | 18.38.58.78 | 95 |
| 0 | X | X | 1 | 1 | 0 | 0 | 1 | 19.39.59.79 | 96 |
| 0 | X | X | 1 | 1 | 0 | 1 | 0 | 1A.3A.5A.7A | 99 |
| 0 | X | X | 1 | 1 | 0 | 1 | 1 | 1B.3B.5B.7B | 9A |
| 0 | X | X | 1 | 1 | 1 | 0 | 0 | 1C.3C.5C.7C | A5 |
| 0 | X | X | 1 | 1 | 1 | 0 | 1 | 1D.3D.5D.7D | A6 |
| 0 | X | X | 1 | 1 | 1 | 1 | 0 | 1E.3E.5E.7E | A9 |
| 0 | X | X | 1 | 1 | 1 | 1 | 0 | 1F.3F.5F.7F | AA |

Group I

| H2 | PAR | DOM | ENV | bit 3 | bit 2 | bit 1 | bit 0 | ADH | DM |
|---|---|---|---|---|---|---|---|---|---|
| 0 | X | 0 | 0 | X | X | X | X | 00/0F-40/4F | C9 |
| 0 | X | 1 | 0 | X | X | X | X | 20/2F-60/6F | 36 |

Group II

| H2 | PAR | DOM | ENV | bit 3 | bit 2 | bit 1 | bit 0 | ADH | DM |
|---|---|---|---|---|---|---|---|---|---|
| 1 | 1 | X | 1 | 0 | 0 | 0 | 0 | D0.F0 | 00 |
| 1 | 0 | X | 1 | 0 | 0 | 0 | 1 | 91.B1 | 00 |
| 1 | 0 | X | 1 | 0 | 0 | 1 | 0 | 92.B2 | 00 |
| 1 | 1 | X | 1 | 0 | 0 | 1 | 1 | D3.F3 | 00 |
| 1 | 0 | X | 1 | 0 | 1 | 0 | 0 | 94.B4 | 00 |
| 1 | 1 | X | 1 | 0 | 1 | 0 | 1 | D5.F5 | 00 |
| 1 | 1 | X | 1 | 0 | 1 | 1 | 0 | D6.F6 | 00 |
| 1 | 0 | X | 1 | 0 | 1 | 1 | 1 | 97.B7 | 00 |
| 1 | 0 | X | 1 | 1 | 0 | 0 | 0 | 98.B8 | 00 |
| 1 | 1 | X | 1 | 1 | 0 | 0 | 1 | D9.F9 | 00 |
| 1 | 1 | X | 1 | 1 | 0 | 1 | 0 | DA.FA | 00 |
| 1 | 0 | X | 1 | 1 | 0 | 1 | 1 | 9B.BB | 00 |
| 1 | 1 | X | 1 | 1 | 1 | 0 | 0 | DC.FC | 00 |
| 1 | 0 | X | 1 | 1 | 1 | 0 | 1 | 9D.BD | 00 |
| 1 | 0 | X | 1 | 1 | 1 | 1 | 0 | 9E.BE | 00 |
| 1 | 1 | X | 1 | 1 | 1 | 1 | 1 | DF.FF | 00 |

Group III

# FIG. 9

| | ADB | ADH | DM |
|---|---|---|---|
| | H2 PAR DOM ENV bit3 bit2 bit1 bit0 | | |
| | 1 0 X 1 0 0 0 0 | 90.B0 | 01 |
| | 1 1 X 1 0 0 0 1 | D1.F1 | 01 |
| | 1 1 X 1 0 0 1 0 | D2.F2 | 01 |
| | 1 0 X 1 0 0 1 1 | 93.B3 | 01 |
| | 1 1 X 1 0 1 0 0 | D4.F4 | 01 |
| | 1 0 X 1 0 1 0 1 | 95.B5 | 01 |
| | 1 0 X 1 0 1 1 0 | 96.B6 | 01 |
| IV | 1 1 X 1 0 1 1 1 | D7.F7 | 01 |
| | 1 1 X 1 1 0 0 0 | D8.F8 | 01 |
| | 1 0 X 1 1 0 0 1 | 99.B9 | 01 |
| | 1 0 X 1 1 0 1 0 | 9A.BA | 01 |
| | 1 1 X 1 1 0 1 1 | DB.FB | 01 |
| | 1 0 X 1 1 1 0 0 | 9C/BC | 01 |
| | 1 1 X 1 1 1 0 1 | DD.FD | 01 |
| | 1 1 X 1 1 1 1 0 | DE.FE | 01 |
| | 1 0 X 1 1 1 1 1 | 9F.BF | 01 |
| V | 1 X X 0 X X X X | 80/8F A0/AF C0/CF E0/EF | 00 |

# F IG .10

FIG.11

## FIG.12

## FIG.13

FIG.14

# FIG.15

EP 0 211 438 B1

# FIG. 16

| AH | AB | DB (par sil sil f bit 3 bit 2 bit 1 bit 0) | DH |
|----|-----|----|----|
| 55 | 0 1 0 1 0 1 0 1 | 1 1 0 0 0 0 0 0 | C0 |
| 56 | 0 1 0 1 0 1 1 0 | 0 1 0 0 0 0 0 1 | 41 |
| 59 | 0 1 0 1 1 0 0 1 | 0 1 0 0 0 0 1 0 | 42 |
| 5A | 0 1 0 1 1 0 1 0 | 1 1 0 0 0 0 1 1 | C3 |
| 65 | 0 1 1 0 0 1 0 1 | 0 1 0 0 0 1 0 0 | 44 |
| 66 | 0 1 1 0 0 1 1 0 | 1 1 0 0 0 1 0 1 | C5 |
| 69 | 0 1 1 0 1 0 0 1 | 1 1 0 0 0 1 1 0 | C6 |
| 6A | 0 1 1 0 1 0 1 0 | 0 1 0 0 0 1 1 1 | 47 |
| 95 | 1 0 0 1 0 1 0 1 | 0 1 0 0 1 0 0 0 | 48 |
| 96 | 1 0 0 1 0 1 1 0 | 1 1 0 0 1 0 0 1 | C9 |
| 99 | 1 0 0 1 1 0 0 1 | 1 1 0 0 1 0 1 0 | CA |
| 9A | 1 0 0 1 1 0 1 0 | 0 1 0 0 1 0 1 1 | 4B |
| A5 | 1 0 1 0 0 1 0 1 | 1 1 0 0 1 1 0 0 | CC |
| A6 | 1 0 1 0 0 1 1 0 | 0 1 0 0 1 1 0 1 | 4D |
| A9 | 1 0 1 0 1 0 0 1 | 0 1 0 0 1 1 1 0 | 4E |
| AA | 1 0 1 0 1 0 1 0 | 1 1 0 0 1 1 1 1 | CF |
| 36 | 0 0 1 1 0 1 1 0 | 0 0 1 0 0 0 0 0 | 20 |
| C9 | 1 1 0 0 1 0 0 1 | 0 0 1 0 0 0 0 0 | 20 |
| Y | X | 0 1 0 1 0 0 0 0 | 50 |

I { (rows 55 through C9)

II { (row Y)

# FIG. 17

# FIG. 18

# FIG. 19